# EUROPÄISCHE PATENTANMELDUNG

(11) **EP 3 211 436 A1**
(43) Veröffentlichungstag der Anmeldung: **30.08.2017**
(21) Anmeldenummer: 16157903.2
(22) Anmeldetag: 29.02.2016
(51) Int. Cl.: G01R 15/20, H02H 1/00, H02H 3/08

(54) **VORRICHTUNG ZUR BERÜHRUNGSLOSEN STROMMESSUNG**

(71) Anmelder: Wöhner GmbH & Co. KG Elektrotechnische Systeme, 96472 Rödental (DE)
(72) Erfinder: Steinberger, Philipp, 96450 Coburg (DE); Steiner, Daniel, 96529 Mengersgereuth-Hämmern (DE); Rau, Maximilian, 96237 Ebersdorf (DE)
(74) Vertreter: Isarpatent

(57) **Zusammenfassung**

Vorrichtung (1) zur berührungslosen Strommessung mindestens eines durch einen Stromleiter (2) fließenden elektrischen Stromes (I) mit einem Magnetfeldschirm (2), welcher den mindestens einen Stromleiter (3) bis auf einen Spaltbereich (4) umschließt und den umschlossenen Raum (5) vor externen Störfeldern abschirmt, wobei ein von dem Stromleiter (3) bei hindurchflie-ßendem elektrischen Strom erzeugtes Magnetfeld in dem Spaltbereich (4) des Magnetfeldschirms linearisierte Feldlinien mit homogenisierter Feldstärke aufweist und mit mindestens einem magnetoresistiven Sensor (6), der in dem Spaltbereich (4) angeordnet ist und das dort bestehende linearisierte und homogenisierte Magnetfeld, dessen Feldstärke der Stromstärke des durch den Stromleiter (3) fließenden elektrischen Stromes (I) entspricht, erfasst.

## Beschreibung

Die Erfindung betrifft eine Vorrichtung zur berührungslosen Strommessung mindestens eines durch einen Stromleiter fließenden elektrischen Stromes.

Zur Strommessung werden bei herkömmlichen ein- oder mehrphasigen Stromversorgungssystemen üblicherweise Stromwandler eingesetzt. Diese Stromwandler enthalten in der Regel einen Eisenkern mit zwei Spulen. Derartige Stromwandler zur Strommessung sind jedoch verhältnismäßig groß und können zudem lediglich Wechselströme und keine Gleichströme detektieren. Zudem weisen derartige herkömmliche Stromwandler bei einer Leistung von beispielsweise 2,5 Watt eine vergleichsweise hohe Leistungsaufnahme auf. Herkömmliche Stromwandler besitzen einen relativ niedrigen Wirkungsgrad. Darüber hinaus sind herkömmliche Stromwandler relativ anfällig gegenüber Umwelteinflüssen, insbesondere gegenüber dem Einfluss von Fremdfeldern sowie gegenüber Temperaturschwankungen. Ein weiterer Nachteil herkömmlicher Stromwandler besteht darin, dass sie nicht ohne Weiteres nachträglich zur Strommessung an einen bereits bestehenden bzw. verlegten Stromleiter montierbar sind. Ein Stromwandler muss zur Strommessung in dem den Stromkreis zur Messung des Stromes eingesetzt werden, wodurch eine zeitweise vorzeitige Unterbrechung des fließenden elektrischen Stromes hervorgerufen wird.

Es ist daher eine Aufgabe der vorliegenden Erfindung, eine Vorrichtung zur Strommessung eines durch einen Stromleiter fließenden elektrischen Stromes zu schaffen, die ohne Unterbrechung des zu messenden Strompfades an den Stromleiter anbringbar ist und sowohl Gleichströme als auch Wechselströme, die durch den Stromleiter fließen, zuverlässig und robust gegenüber Umwelteinflüsse misst.

Diese Aufgabe wird erfindungsgemäß durch eine Vorrichtung mit den in Patentanspruch 1 angegebenen Merkmalen gelöst.

Die Erfindung schafft demnach eine Vorrichtung zur berührungslosen Strommessung mindestens eines durch einen Stromleiter fließenden elektrischen Stromes mit einem Magnetfeldschirm, welcher den mindestens einen Stromleiter bis auf einen Spaltbereich umschließt und den umschlossenen Raum vor externen Störfeldern abschirmt, wobei ein von dem Stromleiter bei hindurchfließendem elektrischen Strom erzeugtes Magnetfeld in dem Spaltbereich des Magnetfeldschirms linearisierte Feldlinien mit homogenisierter Feldstärke aufweist und
mit mindestens einem magnetoresistiven Sensor, der in dem Spaltbereich angeordnet ist und das dort bestehende linearisierte und homogenisierte Magnetfeld, dessen Feldstärke der Stromstärke des durch den Stromleiter fließenden elektrischen Stromes entspricht, erfasst.

Die erfindungsgemäße Vorrichtung ermöglicht es, sowohl Gleich- als auch Wechselströme bei einem ein- und/oder mehrphasigen Stromversorgungssystem berührungslos zu messen. Dabei kann die Vorrichtung an eine bereits bestehende bzw. verlegte Stromleitung, insbesondere Stromversorgungsleitung, für ein Gerät ohne Weiteres nachträglich angebracht werden, ohne dass der betreffende Stromkreis bzw. Strompfad unterbrochen wird. Die erfindungsgemäße Vorrichtung zur berührungslosen Strommessung ermöglicht somit eine nachträgliche Montage, auch bekannt als "Retrofit".

Ein weiterer Vorteil der erfindungsgemäßen Vorrichtung zur berührungslosen Strommessung besteht darin, dass sie gegenüber Umwelteinflüssen, insbesondere gegenüber dem Einfluss von Fremdfeldern, unempfindlich ist.

Ein weiterer Vorteil der erfindungsgemäßen Vorrichtung zur berührungslosen Strommessung besteht darin, dass sie gegenüber starken Temperaturschwankungen und gegenüber hohen Temperaturen, die oberhalb eines üblichen Betriebstemperaturbereiches von etwa -5°C bis +55°C liegen, unempfindlich ist. Ein weiterer signifikanter Vorteil der erfindungsgemäßen Vorrichtung zur berührungslosen Strommessung besteht darin, dass ihr Energiebedarf gering ist.

Ein weiterer Vorteil der erfindungsgemäßen Vorrichtung zur berührungslosen Strommessung besteht darin, dass diese Vorrichtung besonders platzsparend ist und auch bei kleineren Geräten eingesetzt werden kann.

Bei einer möglichen Ausführungsform der erfindungsgemäßen Vorrichtung ist der Magnetfeldschirm derart ausgebildet, dass er den Stromleiter u-förmig umschließt.

Bei einer weiteren möglichen Ausführungsform der erfindungsgemäßen Vorrichtung ist der Magnetfeldschirm derart ausgebildet, dass er den Stromleiter nahezu ringförmig umschließt.

Bei einer weiteren möglichen Ausführungsform der erfindungsgemäßen Vorrichtung weist der Magnetfeldschirm mehrere Schirmteile auf.

Bei einer möglichen Ausführungsform der erfindungsgemäßen Vorrichtung sind diese Schirmteile des Magnetfeldschirms gelenkig miteinander verbunden und umschließen den Stromleiter nahezu vollständig bis auf den Spaltbereich.

Bei einer möglichen Ausführungsform der erfindungsgemäßen Vorrichtung weist der u-förmig ausgebildete Magnetfeldschirm zwei gegenüberliegende Schenkel auf, wobei sich zwischen den beiden parallel verlaufenden Schenkeln der offene Spaltbereich des Magnetfeldschirms befindet.

Bei einer weiteren möglichen Ausführungsform der erfindungsgemäßen Vorrichtung ist der den Stromleiter nahezu ringförmig umschließende Magnetfeldschirm rohrschellenförmig ausgebildet.

Bei einer möglichen Ausführungsform der erfindungsgemäßen Vorrichtung sind die beiden Endabschnitte des rohrschellenförmig ausgebildeten Magnetfeldschirms nach außen gebogen und verlaufen zueinander parallel, wobei sich zwischen den beiden Endabschnitten der offene Spaltbereich des Magnetfeldschirms befindet.

Bei einer möglichen Ausführungsform der erfindungsgemäßen Vorrichtung ist der magnetoresistive Sensor, der in dem Spaltbereich des Magnetfeldschirms angeordnet ist, ein GMR-Sensor.

Bei einer weiteren möglichen Ausführungsform der erfindungsgemäßen Vorrichtung ist der magnetoresistive Sensor, der in dem Spaltbereich des Magnetfeldschirms angeordnet ist, ein TMR-Sensor.

Bei einer weiteren möglichen alternativen Ausführungsform der erfindungsgemäßen Vorrichtung ist der magnetoresistive Sensor, der in dem Spaltbereich des Magnetfeldschirms angeordnet ist, ein AMR-Sensor.

Bei einer weiteren möglichen alternativen Ausführungsform der erfindungsgemäßen Vorrichtung ist der magnetoresistive Sensor, der in dem Spaltbereich des Magnetfeldschirms angeordnet ist, ein Hall-Sensor.

Bei einer weiteren möglichen Ausführungsform der erfindungsgemäßen Vorrichtung ist in dem von dem Magnetfeldschirm umschlossenen Raum ein Mikrocontroller zur Signalauswertung eines von dem magnetoresistiven Sensor abgegebenen Messsignals angeordnet.

Bei einer weiteren möglichen Ausführungsform der erfindungsgemäßen Vorrichtung schützt der Magnetfeldschirm den Mikro-controller vor externen Störfeldern und/oder vor einer zu hohen Feldbelastung durch das von dem mindestens einen Stromleiter erzeugte Magnetfeld.

Bei einer weiteren möglichen Ausführungsform der erfindungsgemäßen Vorrichtung ist der von dem Magnetfeldschirm umschlossene Stromleiter ein flexibler oder starrer Stromleiter mit einem bestimmten Querschnitt.

Bei einer möglichen Ausführungsform der erfindungsgemäßen Vorrichtung weist der von dem Magnetfeldschirm umschlossene Stromleiter einen Rundstromleiter mit kreisförmigem Querschnitt auf.

Bei einer alternativen möglichen Ausführungsform der erfindungsgemäßen Vorrichtung weist der von dem Magnetfeldschirm umschlossene Stromleiter einen Stromleiter mit rechteckigem Querschnitt, insbesondere eine Stromsammelschiene, auf.

Bei einer weiteren möglichen Ausführungsform der erfindungsgemäßen Vorrichtung sind die gelenkig miteinander verbundenen Schirmteile des mehrteiligen Magnetfeldschirms auf den mindestens einen umschlossenen Stromleiter aufrastbar.

Bei einer möglichen Ausführungsform der erfindungsgemäßen Vorrichtung umschließt der Magnetfeldschirm eine auf einer Platine verlaufende Leiterbahn.

Bei einer weiteren möglichen Ausführungsform der erfindungsgemäßen Vorrichtung umschließt der Magnetfeldschirm eine in einer Platine integrierte Leiterbahn.

Bei einer weiteren möglichen Ausführungsform der erfindungsgemäßen Vorrichtung verläuft die Sensitivitätsachse des magnetoresistiven Sensors parallel zu Magnetfeldlinien in dem Spaltbereich des Magnetfeldschirms.

Bei einer weiteren möglichen Ausführungsform der erfindungsgemäßen Vorrichtung ragen die Endabschnitte der beiden gegenüberliegenden Schenkel des u-förmigen Magnetfeldschirms oder der beiden Endabschnitte des rohrschellenförmigen Magnetfeldschirms durch zwei entsprechende Öffnungen einer Platine auf einer ersten Seite der Platine heraus, wobei sich zwischen den beiden herausragenden Endabschnitten der offene Spaltbereich des Magnetfeldschirms befindet und der magnetoresistive Sensor auf der ersten Seite der Platine in dem offenen Spaltbereich angeordnet ist.

Bei einer weiteren möglichen Ausführungsform der erfindungsgemäßen Vorrichtung ist der Stromleiter eine auf der entgegengesetzten zweiten Seite der Platine verlaufende Leiterbahn oder eine in der Platine integrierte Leiterbahn, die von dem Magnetfeldschirm umschlossen ist.

Bei einer weiteren möglichen Ausführungsform der erfindungsgemäßen Vorrichtung erfasst der magnetoresistive Sensor einen durch den Stromleiter fließenden Gleichstrom und/oder einen durch den Stromleiter fließenden Wechselstrom und/oder einen durch den Stromleiter fließenden gepulsten Strom einschließlich Oberwellen berührungslos.

Bei einer weiteren möglichen Ausführungsform der erfindungsgemäßen Vorrichtung leitet der mindestens eine Stromleiter eine Stromphase für ein an ein Stromversorgungsnetz angeschlossenes Gerät.

Bei einer möglichen Ausführungsform der erfindungsgemäßen Vorrichtung weist der Magnetfeldschirm ein amorphes Metall mit hoher Permeabilität und niedriger Remanenz auf.

Bei einer möglichen speziellen Ausführungsform der erfindungsgemäßen Vorrichtung weist das amorphe Metall ein nickelhaltiges amorphes Metall, insbesondere Supra 50 oder Permalloy 80, auf.

Bei einer weiteren möglichen Ausführungsform der erfindungsgemäßen Vorrichtung umschließt der Magnetfeldschirm mindestens zwei parallel angeordnete Stromleiter.

Bei einer weiteren möglichen Ausführungsform der erfindungsgemäßen Vorrichtung werden die beiden parallel angeordneten Stromleiter antiparallel von zwei verschiedenen elektrischen Strömen, insbesondere von einem Hin- und Rückstrom, durchflossen, wobei der magnetoresistive Sensor eine Differenzstromstärke zwischen den Stromstärken der beiden elektrischen Ströme berührungslos erfasst.

Bei einer weiteren alternativen Ausführungsform der erfindungsgemäßen Vorrichtung werden die parallel angeordneten Stromleiter parallel von in gleicher Richtung fließenden elektrischen Strömen durchflossen, wobei der magnetoresistive Sensor eine Summenstromstärke der Stromstärken der parallel fließenden elektrischen Ströme berührungslos erfasst.

Bei einer weiteren möglichen Ausführungsform der erfindungsgemäßen Vorrichtung ist eine Auswerteeinheit vorgesehen, die die sensorisch erfassten Stromstärken des mindestens einen Stromleiters, einer Summenstromstärke oder eine Differenzstromstärke auswertet.

Bei einer weiteren möglichen Ausführungsform der erfindungsgemäßen Vorrichtung weist die Vorrichtung eine Steuereinheit auf, die in Abhängigkeit von einem von der Auswerteeinheit gelieferten Auswerteergebnis einen Aktor ansteuert.

Bei einer weiteren möglichen Ausführungsform der erfindungsgemäßen Vorrichtung überträgt die Auswerteeinheit das Auswerteergebnis an eine externe Steuerung.

Die Erfindung schafft gemäß einem weiteren Aspekt eine Strommessvorrichtung mit mindestens einem u-förmigen oder ringförmigen Magnetfeldschirm, der zur Strommessung eines zu mindestens einer Last durch einen zugehörigen Stromleiter fließenden elektrischen Stromes ohne dessen Unterbrechung den mindestens einen Stromleiter bis auf einen Spaltbereich umschließend an dem mindestens einen Stromleiter montierbar ist.

Die Erfindung schafft gemäß einem weiteren Aspekt ein Strommessgerät mit einer Strommessvorrichtung gemäß dem ersten Aspekt der Erfindung zur Messung eines durch den Stromleiter fließenden elektrischen Gleichstromes und/oder eines durch den Stromleiter fließenden elektrischen Wechselstromes.

Bei einer möglichen Ausführungsform ist dieses Strommessgerät als Strommesszange ausgebildet.

Bei einer möglichen Ausführungsform des erfindungsgemäßen Strommessgerätes weist dieses eine Auswerteeinheit zur Auswertung der gemessenen Stromstärke, eine Anzeigeeinheit zur Anzeige der gemessenen Stromstärke und/oder eine Sendeeinheit zur drahtlosen Übertragung der gemessenen Stromstärke an eine externe Empfangseinheit eines mobilen Gerätes, insbesondere eines Mobilfunkgerätes, auf.

Bei einer möglichen Ausführungsform des erfindungsgemäßen Strommessgerätes ist dieses an eine Stromsammelschiene des Stromsammelschienensystems montierbar.

Im Weiteren werden mögliche Ausführungsformen der erfindungsgemäßen Vorrichtung zur berührungslosen Strommessung unter Bezugnahme auf die beigefügten Figuren näher erläutert.

Es zeigen:
- Fig. 1: eine schematische Darstellung einer möglichen exemplarischen Ausführungsform der erfindungsgemäßen Vorrichtung zur berührungslosen Strommessung;
- Fig. 2: eine perspektivische Ansicht zur Darstellung einer möglichen Ausführungsform eines in der erfindungsgemäßen Vorrichtung verwendeten Magnetfeldschirms;
- Fig. 3: ein Blockschaltbild zur Darstellung eines Strommessprinzips, welches bei der erfindungsgemäßen Vorrichtung verwendet werden kann;
- Fig. 4: eine Abbildung der Auswirkung einer Verschiebung eines magnetoresistiven Sensors, wie er bei der erfindungsgemäßen Vorrichtung verwendet werden kann, in eine Richtung zusammen mit dem Magnetfeldschirm der erfindungsgemäßen Vorrichtung;
- Fig. 5: eine Darstellung der Auswirkung einer Verschiebung des magnetoresistiven Sensors, der bei der erfindungsgemäßen Vorrichtung verwendet werden kann, in eine Richtung ohne Magnetfeldschirm;
- Fig. 6: eine schematische Darstellung der Magnetfeldlinien, insbesondere in einem Spaltbereich zwischen Endabschnitten eines u-förmigen Magnetfeldschirms, wie er bei der erfindungsgemäßen Vorrichtung zur berührungslosen Strommessung verwendet werden kann;
- Fig. 7: eine Darstellung einer durch einen Magnetfeldschirm der erfindungsgemäßen Vorrichtung vorgenommene Magnetfeldschirmung eines Störfeldes zur Erläuterung der Funktionsweise der erfindungsgemäßen Vorrichtung zur berührungslosen Strommessung;
- Fig. 8: eine schematische Darstellung einer exemplarischen Ausführungsform der erfindungsgemäßen Vorrichtung zur berührungslosen Strommessung eines durch einen Stromleiter hindurchfließenden elektrischen Stromes;
- Fig. 9: eine perspektivische Ansicht auf eine klappbare Ausführungsform der erfindungsgemäßen Vorrichtung zur berührungslosen Strommessung bei einer Sammelschiene;
- Fig. 10: eine perspektivische Ansicht auf die in Fig. 9 dargestellte klappbare Ausführungsform der erfindungsgemäßen Vorrichtung nach Montage an einer Sammelschiene;
- Fig. 11: eine perspektivische Ansicht zur Darstellung eines inneren Aufbaus der in Fig. 9, 10 dargestellten klappbaren Ausführungsform der erfindungsgemäßen Vorrichtung zur berührungslosen Strommessung;
- Fig. 12: eine Darstellung eines weiteren exemplarischen Ausführungsbeispiels einer auf einer Stromleitung montierbaren Vorrichtung zur berührungslosen Strommessung;
- Fig. 13: eine weitere Ausführungsvariante einer erfindungsgemäßen Vorrichtung zur berührungslosen Strommessung;
- Fig. 14: eine perspektivische Darstellung einer in der Vorrichtung gemäß Fig. 13 verwendeten Magnetfeldschirmung;
- Fig. 15: eine Darstellung des inneren Aufbaus der in Fig. 13, 14 dargestellten Ausführungsform der erfindungsgemäßen Vorrichtung zur berührungslosen Strommessung an einem Stromleiter;
- Fig. 16: eine Schnittansicht einer weiteren möglichen Ausführungsvariante der erfindungsgemäßen Vorrichtung zur berührungslosen Strommessung;
- Fig. 17: eine weitere Schnittansicht zur Darstellung einer weiteren Ausführungsvariante der erfindungsgemäßen Vorrichtung zur berührungslosen Strommessung;
- Fig. 18: eine perspektivische Ansicht einer weiteren Ausführungsvariante der erfindungsgemäßen Vorrichtung zur berührungslosen Strommessung;
- Fig. 19: eine perspektivische Darstellung einer Ausführungsvariante der erfindungsgemäßen Vorrichtung zur berührungslosen Strommessung;
- Fig. 20: ein Schaltkreisdiagramm zur Darstellung eines Anwendungsbeispiels der erfindungsgemäßen Vorrichtung zur berührungslosen Strommessung;
- Fig. 21: ein weiteres Schaltkreisdiagramm zur Darstellung eines weiteren Anwendungsbeispiels der erfindungsgemäßen Vorrichtung zur berührungslosen Strommessung;
- Fig. 22: ein Schaltkreisdiagramm zur Darstellung einer weiteren Ausführungsform der erfindungsgemäßen Vorrichtung zur berührungslosen Strommessung;
- Fig. 23: eine schematische perspektivische Darstellung einer möglichen Ausführungsform der in Fig. 2 dargestellten Ausführungsvariante der erfindungsgemäßen Vorrichtung zur berührungslosen Strommessung;
- Fig. 24: eine schematische Darstellung einer möglichen weiteren Ausführungsvariante der erfindungsgemäßen Vorrichtung zur berührungslosen Strommessung.
- Fig. 25: eine Darstellung einer weiteren Ausführungsform der erfindungsgemäßen Vorrichtung zur berührungslosen Strommessung.

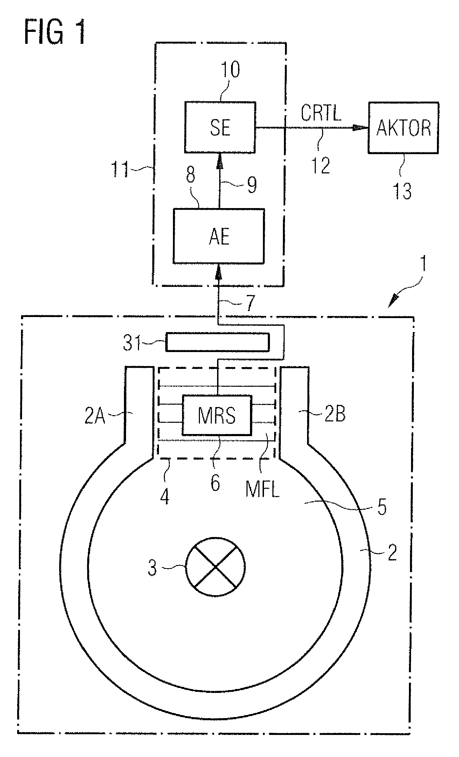

Wie man aus der schematischen Darstellung gemäß Fig. 1 erkennen kann, weist die erfindungsgemäße Vorrichtung 1 zur berührungslosen Strommessung mindestens eines durch einen Stromleiter hindurchfließenden elektrischen Stromes I in dem dargestellten Ausführungsbeispiel einen Magnetfeldschirm 2 auf, welcher mindestens einen Stromleiter 3 bis auf einen Spaltbereich 4 umschließt und den umschlossenen Raum 5, in welchem sich der mindestens eine Stromleiter 3 befindet, gegenüber externen Störfeldern abschirmt. Der Spaltbereich 4 befindet sich bei dem in Fig. 1 dargestellten Ausführungsbeispiel zwischen zwei Endabschnitten 2A, 2B des rohrschellenförmig ausgebildeten Magnetfeldschirms 2, wie er in Fig. 1 dargestellt ist. Die beiden Endabschnitte 2A, 2B des rohrschellenförmig ausgebildeten Magnetfeldschirms 2 sind nach außen gebogen und verlaufen zueinander im Wesentlichen parallel, wobei sich zwischen den beiden Endabschnitten 2A, 2B der offene Spaltbereich 4 des Magnetfeldschirms 2 befindet. Der Spaltbereich 4 ist in Fig. 1 gestrichelt umrandet dargestellt. Bei der in Fig. 1 dargestellten Ausführungsform umschließt der Magnetfeldschirm 2 den Stromleiter 3 nahezu ringförmig bis auf den Spaltbereich 4. Bei einer alternativen Ausführungsform kann der Magnetfeldschirm 2 auch u-förmig ausgebildet sein. Durch den Stromleiter 3 fließt ein elektrischer Strom I.

Der durch den Stromleiter 3 hindurchfließende Strom I erzeugt ein Magnetfeld. Das von dem Stromleiter 3 bei hindurchfließendem Strom I erzeugte Magnetfeld weist in dem Spaltbereich 4 des Magnetfeldschirms 2 linearisierte Feldlinien mit homogenisierter Feldstärke auf. Dabei verlaufen die Magnetfeldlinien MFL des erzeugten Magnetfelds im Wesentlichen senkrecht zu den inneren Oberflächen der beiden Endabschnitte 2A, 2B des Magnetfeldschirms 2. In Fig. 1 sind die Magnetfeldlinien MFL schematisch angedeutet. Die erfindungsgemäße Vorrichtung 1 zur berührungslosen Strommessung weist mindestens einen magnetoresistiven Sensor 6 auf, der in dem Spaltbereich 4 angeordnet ist und das dort bestehende linearisierte und homogenisierte Magnetfeld, dessen Feldstärke der Stromstärke I des durch den Stromleiter 3 hindurchfließenden elektrischen Stromes 1 entspricht, erfasst.

Bei einer möglichen bevorzugten Ausführungsform der erfindungsgemäßen Strommessvorrichtung 1 zur berührungslosen Strommessung weist der magnetoresistive Sensor 6 einen GMR-Sensor auf. Bei einer alternativen Ausführungsform weist der magnetoresistive Sensor 6 einen TMR-Sensor oder einen AMR-Sensor auf. Bei einer weiteren möglichen Ausführungsform der erfindungsgemäßen Vorrichtung zur berührungslosen Strommessung weist der magnetoresistive Sensor 6 einen Hall-Sensor auf.

Der magnetoresistive Sensor 6 erzeugt ein Messsignal, welches über eine Signalleitung oder einen Signalbus 7 zu einer Auswerteeinheit 8 geleitet wird, wie in Fig. 1 dargestellt. Die Auswerteeinheit 8 wertet die sensorisch erfasste Stromstärke aus und kann bei einer möglichen Ausführungsform das Auswerteergebnis über eine Leitung 9 an eine Steuereinheit 10 ausgeben. Bei einer möglichen Ausführungsform können die Auswerteeinheit 8 und die Steuereinheit 10 in einem Prozessor bzw. Mikroprozessor 11 integriert sein. Die Auswertung der sensorisch erfassten Stromstärke erfolgt bei dieser Ausführungsform nach Umwandlung des analogen Messsignals durch digitale Auswerte- und Steuerschaltkreise. Die Steuereinheit 10 steuert bei dem in Fig. 1 dargestellten Ausführungsbeispiel über eine Steuerleitung 12 in Abhängigkeit des Auswerteergebnisses einen Aktor 13 an. Der Aktor 13 kann beispielsweise eine Schalteinheit aufweisen. Bei einer möglichen Ausführungsvariante wird ein Schalter welche in der Stromleitung 3 leigt, geschaltet und unterbricht beim Öffnen den entsprechenden Strompfad bzw. Stromkreis.

Der Magnetfeldschirm 2 der in Fig. 1 dargestellten Strommessvorrichtung 1 kann bei einer möglichen Ausführungsvariante mehrere Schirmteile aufweisen. Diese Schirmteile sind bei einer möglichen Ausführungsform gelenkig miteinander verbunden und können den Stromleiter 3 umschließen. Bei einer möglichen Ausführungsform ist der Magnetfeldschirm 2, wie in Fig. 1 dargestellt, rohrschellenförmig ausgebildet. Bei einer möglichen Ausführungsvariante ist der in Fig. 1 dargestellte Mikroprozessor bzw. Mikrocontroller 11 in dem von dem Magnetfeldschirm 2 umschlossenen Raum angeordnet und dient zur Signalauswertung eines von dem magnetoresistiven Sensor 6 abgegebenen Messsignals. Bei dieser Ausführungsform schützt der Magnetfeldschirm 2 den Mikrocontroller 11 vor externen Störfeldern und einer zu hohen Feldbelastung durch ein fremdes Magnetfeld und/oder vor dem durch den Stromleiter 3 erzeugten Magnetfeld.

Der Stromleiter 3 ist bei einer möglichen Ausführungsform ein flexibler oder starrer Stromleiter mit einem bestimmten Querschnitt, welcher von dem Magnetfeldschirm 2 umschlossen wird. Bei einer möglichen Ausführungsform ist der von dem Magnetfeldschirm 2 umschlossene Stromleiter 3 ein Rundstromleiter mit einem kreisförmigen Querschnitt. Bei einer alternativen Ausführungsform ist der Stromleiter 3 ein Stromleiter mit rechteckigem Querschnitt. Bei einer möglichen Ausführungsform handelt es sich bei dem Stromleiter 3 um eine Stromsammelschiene eines Stromsammelschienensystems.

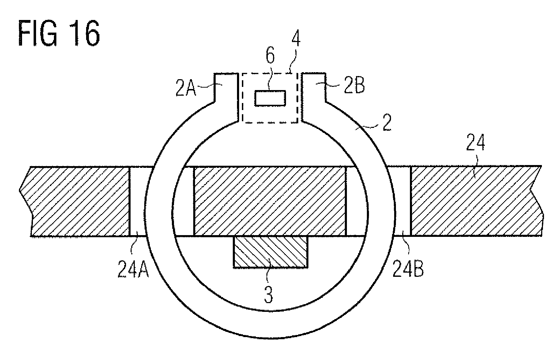

Bei einer möglichen Ausführungsform weist der Magnetfeldschirm 2 mehrere gelenkig miteinander verbundene Schirmteile auf, die auf den Stromleiter 3 mechanisch aufrastbar sind. Alternativ kann der Magnetfeldschirm 2 auch eine auf einer Platine verlaufende Leiterbahn oder eine in einer Platine integrierte Leiterbahn umschließen. Bei dieser Ausführungsform ragen die Endabschnitte 2A, 2B des rohrschellenförmigen Magnetfeldschirms 2 vorzugsweise durch zwei entsprechende Öffnungen der Platine auf einer Seite der Platine heraus, wobei sich zwischen den beiden herausragenden Endabschnitten ein offener Spaltbereich des Magnetfeldschirms 2 befindet und der magnetoresistive Sensor auf der ersten Seite der Platine in dem offenen Spaltbereich 4 angeordnet ist. Eine solche Ausführungsvariante ist beispielsweise in Fig. 16 dargestellt. Bei der in Fig. 1 dargestellten Ausführungsform verläuft die Sensitivitätsachse des magnetoresistiven Sensors 6 vorzugsweise parallel zu den Magnetfeldlinien MFL des in dem Spaltbereich 4 des Magnetfeldschirms 2 vorhandenen Magnetfeldes.

Die erfindungsgemäße Vorrichtung 1 zur berührungslosen Strommessung eignet sich sowohl zur Gleichstrommessung als auch zur Wechselstrommessung. Durch den magnetoresistiven Sensor 6 wird sowohl ein durch den Stromleiter 3 hindurchfließender Gleichstrom (DC) als auch ein durch den Stromleiter 3 hindurchfließender Wechselstrom (AC) berührungslos erfasst. Der magnetoresistive Sensor 6 erfasst ein elektrisches Stromsignal einer beliebigen Form, beispielsweise einen gepulsten Strom oder einen sägezahnförmigen Strom. Dabei werden bei der erfindungsgemäßen berührungslosen Strommessvorrichtung 1 durch den magnetoresistiven Sensor 6 auch mögliche Oberwellen des durch den Stromleiter 3 hindurchfließenden elektrischen Stromsignals miterfasst. Bei einer möglichen Ausführungsvariante werden diese Oberwellen durch die Auswerteeinheit 8 ermittelt. Bei einer möglichen Ausführungsform leitet der Stromleiter 3 eine Stromphase L an ein an einem Stromversorgungsnetz angeschlossenes Gerät. Bei dem Gerät kann es sich beispielsweise um einen Elektromotor oder dergleichen handeln.

Bei einer bevorzugten Ausführungsform weist der Magnetfeldschirm 2 ein amorphes Metall mit hoher Permeabilität und niedriger Remanenz auf. Bei einer Ausführungsvariante weist das amorphe Metall ein nickelhaltiges amorphes Metall, insbesondere Supra 50 oder Permalloy 80 auf. Bei diesen Materialien handelt es sich um Nickel-Eisen-Legierungen mit unterschiedlichem Mischungsverhältnis. Dabei weist das sogenannte Supra 50 einen Nickelanteil von etwa 50 % auf. Das sogenannte Permalloy 80 oder auch Mu-Metall besitzt demgegenüber einen Nickelanteil von etwa 80 %. Die beiden Materialien (Supra 50, Permalloy 80) besitzen ähnliche magnetische Eigenschaften bezüglich Permeabilität und Koerzitivfeldstärke, wobei beide Stoffe bzw. Materialien eine geringe Remanenz bei gleichzeitiger hoher Permeabilität besitzen. Die Metalle erhalten dabei die gewünschte magnetischen Eigenschaften im Zuge einer Wärmebehandlung unter Schutzatmosphäre.

Supra 50 hat bei einer möglichen Ausführungsform die folgende Zusammensetzung: 47,5 % Nickel, 0,5 % Mn, 0,1 % Si, 0,005 % C und 51,895 % Fe.

Demgegenüber besitzt Permalloy 80 die folgende Zusammensetzung: 80 % Nickel, 0,5 % Mn, 4,4 % Mo, 0,3 % Si und 14,8 % Fe.

Supra 50 besitzt eine Permeabilität (*µ*ₘₐₓ) von 190.000, eine Koerzitivfeldstärke (A/M) von etwa 2,8 sowie eine Sättigungspolarisation (T) von 1,5. Demgegenüber besitzt Permalloy 80 eine höhere Permeabilität (*µ*ₘₐₓ) von etwa 250.000, eine etwas geringere Koerzitivfeldstärke (A/M) von 1,5 und eine Sättigungspolarisation (T) von 0,8.

Bei einer möglichen Ausführungsform kann mindestens ein weiterer Magnetfeldschirm 31 vorgesehen sein, wie in Fig. 1 angedeutet, welcher den magnetoresistiven Sensor 6 zusätzlich abschirmt, insbesondere vor Störfeldern.

Die erfindungsgemäße Strommessvorrichtung 1 erlaubt eine berührungslose Strommessung ohne Unterbrechung des zu messenden Strompfades. Die Strommessvorrichtung 1 besitzt einen Magnetfeldschirm 2, der zur Strommessung eines zumindest an einer Last durch den zugehörigen Stromleiter 3 hindurchfließenden elektrischen Stromes ohne dessen Unterbrechung den mindestens einen Stromleiter 3 bis auf den Spaltbereich 4 umschließend an den mindestens einen Stromleiter 3 montierbar ist. Die Strommessvorrichtung 1 ist somit nachträglich an einer bereits vorhandenen bzw. verlegten Stromleitung 3 nachträglich anbringbar bzw. montierbar, ohne den Stromfluss innerhalb des Stromleiters 3 unterbrechen zu müssen. Durch den Magnetfeldschirm 2 wird eine Homogenisierung und Linearisierung des Magnetfeldes innerhalb des Spaltbereichs 4 erreicht. Darüber hinaus bietet der Magnetfeldschirm 2 eine Abschirmung gegenüber Fremd- bzw. Störfeldern. Die erfindungsgemäße Vorrichtung 1 zur berührungslosen Strommessung kann an verschiedenartige Stromleiter mit unterschiedlichen Querschnitten montiert werden, beispielsweise auch an Stromleiter mit rechteckförmigem Querschnitt, insbesondere an Stromsammelschienen oder dergleichen.

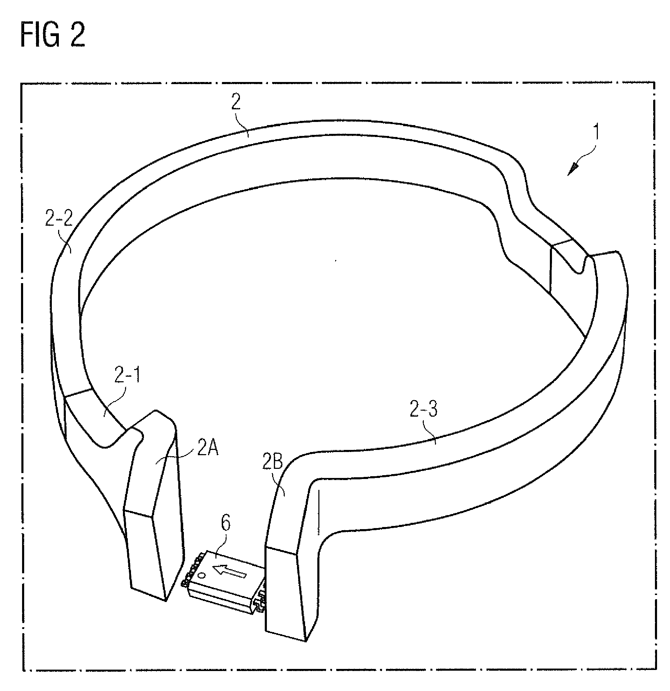

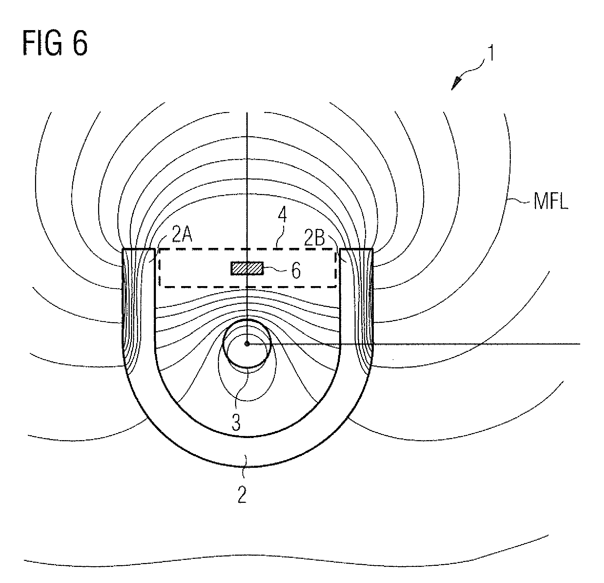

Fig. 2 zeigt eine perspektivische Ansicht auf eine Ausführungsvariante der erfindungsgemäßen Strommessvorrichtung 1 mit einem rohrschellenförmig ausgebildeten Magnetfeldschirm 2, der zwei distale Endabschnitte 2A, 2B besitzt, die einen Spaltbereich 4 definieren, in welchem sich der magnetoresistive Sensor 6 befindet. Bei dem in Fig. 2 dargestellten Ausführungsbeispiel besteht der Magnetfeldschirm 2 aus drei Schirmteilen 2-1, 2-2, 2-3. Die Anzahl der Schirmteile 2-i kann bei unterschiedlichen Ausführungsvarianten und Anwendungsfällen variieren. Der Magnetfeldschirm 2 ist bei dem in Fig. 2 dargestellten Ausführungsbeispiel rohrschellenförmig ausgebildet. Alternativ kann der Magnetfeldschirm 2 auch u-förmig ausgebildet sein, wie beispielsweise in Fig. 6 schematisch dargestellt.

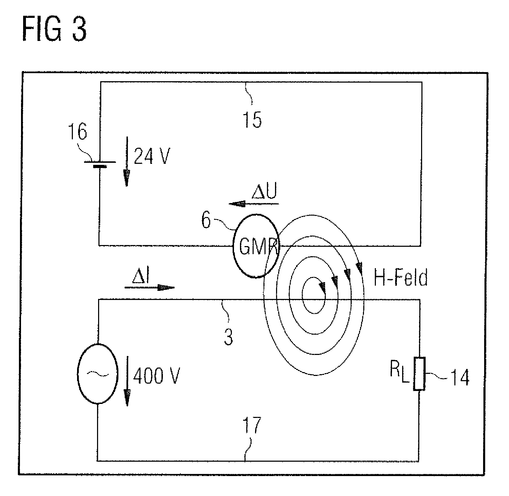

Fig. 3 zeigt ein Ersatzschaltbild zur Erläuterung der Funktionsweise der erfindungsgemäßen Messvorrichtung 1. In Fig. 3 ist der magnetoresistive Sensor ein GMR-Sensor. Die stromdurchflossenen GMR-Schichtanordnung des GMR-Sensors 6 verringert oder vergrößert ihren elektrischen Widerstand, sobald sie einem externen Magnetfeld ausgesetzt wird. Durch den Stromleiter 3 fließt ein elektrischer Strom I zu einer Last 14, wobei im Innenraum 5 des Magnetfeldschirms 2 ein magnetisches Feld erzeugt wird. In dem Spaltbereich 4 des Magnetfeldschirms 2 weist das Magnetfeld linearisierte Feldlinien mit homogenisierter Feldstärke auf. In diesem Spaltbereich 4 ist der GMR-Sensor 6 angeordnet und wird dem linearisierten und homogenisierten Magnetfeld ausgesetzt. Bei dem in Fig. 3 dargestellten Ausführungsbeispiel befindet sich somit der magnetoresistive Sensor 6 bzw. der GMR-Sensor in einem Hilfsstromkreis 15 mit einer Spannungsquelle 16, die beispielsweise 24 Volt liefert. Das Magnetfeld H weist eine Feldstärke auf, die der Stromstärke I des in dem Hauptstromkreis 17 hindurchfließenden elektrischen Stromes I entspricht. Die an dem magnetoresistiven Sensor 6 aufgrund der Widerstandsänderung hervorgerufene Spannungsschwankung 1C kann als Messsignal der Auswerteeinheit 8 über die interne Messleitung 7 zugeführt werden. Bei einer möglichen Ausführungsform wird das analoge Messsignal zunächst mittels eines ADC in ein digitales Signal umgewandelt und durch die Auswerteeinheit 8 anschließend ausgewertet. Bei der in Fig. 3 dargestellten Last Δu kann es sich beispielsweise um ein Elektrogerät, beispielsweise einen Elektromotor oder dergleichen, handeln. Durch den Hauptstromkreis 17 kann beispielsweise eine Stromphase L des Stromversorgungsnetzwerkes an die Last 14 angelegt werden. Wie man aus Fig. 3 erkennen kann, sind der Nebenstromkreis 15, in welchem sich der magnetoresistive Sensor 6 befindet, und der Hauptstromkreis 17, in welchem sich die zu versorgende Last 14 befindet, voneinander vollständig galvanisch getrennt. Der magnetoresistive Sensor 6 erfasst das durch den Strom I erzeugte Magnetfeld H berührungslos. Durch die berührungslose Strommessung kann eine Strommessung ohne irgendeinen Eingriff in den Hauptstromkreis 17 erreicht werden. Ist die Stromleitung 3 des Hauptstromkreises 17 bereits vorhanden bzw. verlegt, kann eine berührungslose Strommessung der erfindungsgemäßen Vorrichtung 1 ohne Unterbrechung des Stromflusses erfolgen. Eine bestehende Anlage mit Stromleitungen kann daher ohne Unterbrechung des Stromflusses bzw. des Betriebes der Anlage ohne Weiteres mit einer oder mehreren Vorrichtungen 1 zur berührungslosen Strommessung nachgerüstet werden.

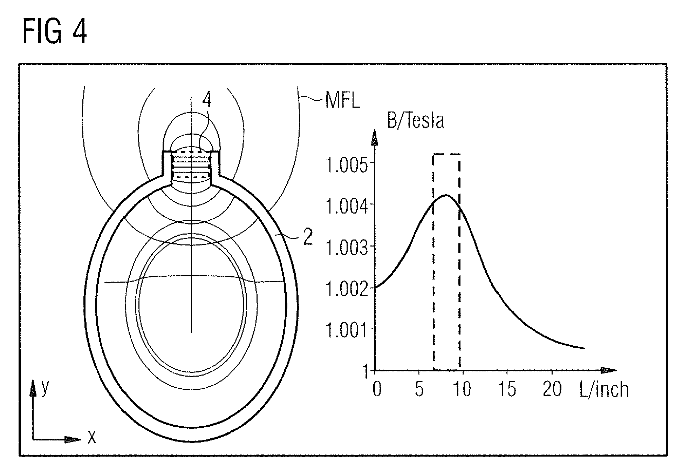

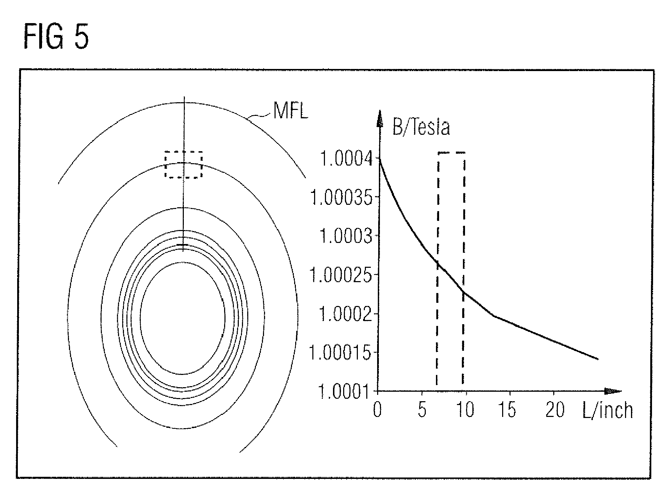

Durch den Magnetfeldschirm 2 wird das Magnetfeld H um den magnetoresistiven Sensor 6 herum linearisiert und homogenisiert. Der Bereich, in dem der magnetoresistive Sensor 6 angeordnet ist, ist in den Figuren 4, 5 gestrichelt dargestellt. Wie man aus dem Diagramm gemäß Fig. 4 erkennen kann, hat eine Verschiebung des magnetoresistiven Sensors 6 im Spaltbereich 4 in y-Richtung bei Vorhandensein eines Magnetfeldschirms 2 eine maximale Abweichung von 4 % zur Folge. Demgegenüber hat eine Verschiebung eines magnetoresistiven Sensors 6 ohne Vorhandensein eines Magnetfeldschirms 2 bei gleicher Verschiebung eine Abweichung von bis zu 20 % zur Folge, wie aus dem Diagramm gemäß Fig. 5 hervorgeht.

Fig. 6 zeigt eine weitere mögliche Ausführungsform der erfindungsgemäßen Vorrichtung 1 zur berührungslosen Strommessung. Bei der in Fig. 6 dargestellten Ausführungsform ist der Magnetfeldschirm 2 u-förmig ausgebildet. Der Magnetfeldschirm 2 umschließt einen Stromleiter 3 u-förmig und besitzt zwei Endabschnitte 2A, 2B, die einen Spaltbereich 4 definieren. In diesem Spaltbereich 4 ist der magnetoresistive Sensor 6 der Strommessvorrichtung 1 platziert bzw. angeordnet. Fig. 2 zeigt die durch einen Stromfluss durch den Stromleiter 3 hervorgerufenen Magnetfeldlinien MFL schematisch. Der u-förmige Magnetfeldschirm 2 wird um den gemessenen Stromleiter 3 gelegt. Durch den Magnetfeldschirm 2 werden die Magnetfeldlinien MFL des Magnetfeldes H im Inneren der u-Form linearisiert. Ohne das Vorhandensein des Magnetfeldschirms 2 würde der Stromleiter 3 ein kreisrundes Magnetfeld ausbilden, sodass ein Sensor, der nur entlang einer Achse sensitiv ist, nicht optimal arbeiten könnte. Neben der Feldlinearisierung bietet die erfindungsgemäße Anordnung auch eine Feldhomogenisierung. Während die Feldstärke ohne Vorhandensein eines Magnetfeldschirms 2 indirekt proportional zum Leiterabstand abfällt (1/R), wie in Fig. 5 erkennbar, erfolgt durch den Magnetfeldschirm 2 eine Vergleichmäßigung der Feldstärke im Spaltbereich 4, wie beispielsweise aus dem Diagramm gemäß Fig. 4 erkennbar ist.

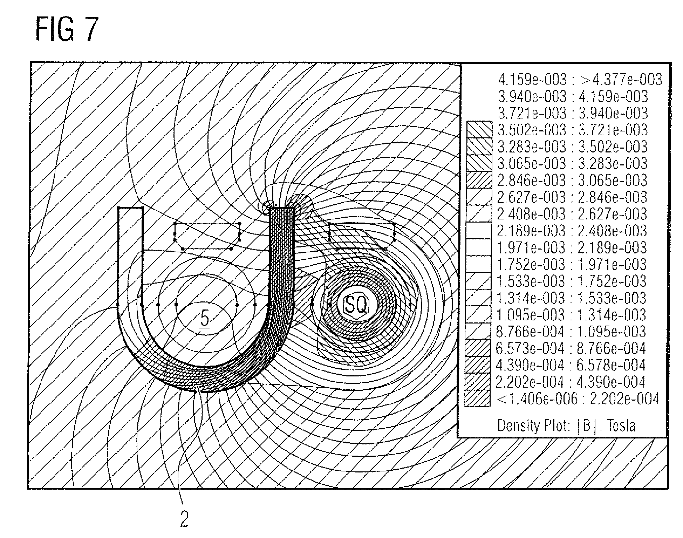

Ein weiterer Vorteil der erfindungsgemäßen Anordnung bzw. Messvorrichtung 1 mit einem rohrschellenförmig aber unförmig ausgebildeten Magnetfeldschirm 2 besteht darin, dass eine Schirmung vor Fremdfeldern bzw. Störfeldern erfolgt. Fig. 7 zeigt schematisch eine Schirmung durch den Magnetfeldschirm 2 vor einem Stör- bzw. Fremdfeld. So kann beispielsweise durch einen in der Nähe verlegten anderen Stromleiter ein starkes symmetrisches Störfeld erzeugt werden. Fig. 7 zeigt eine Störquelle SQ, beispielsweise ein Stromleiter, welcher ein ringförmiges störendes Magnetfeld generiert. Wie man aus Fig. 7 erkennen kann, schirmt der Magnetfeldschirm 2 den Innenraum 5 weitestgehend von dem magnetischen Störfeld ab. Die Feldlinien, die ohne Vorhandensein des Magnetfeldschirms 2 undefiniert durch einen in dem Spaltbereich 4 vorgesehenen magnetoresistiven Sensor 6 verlaufen würden, werden mithilfe des Magnetfeldschirm 2 über dessen Schenkel abgeleitet, wie in Fig. 7 schematisch dargestellt. Durch den Magnetfeldschirm 2 erfolgt somit eine Differenzierung des Störfeldes (senkrecht zum magnetoresistiven Sensor abgeleitet, nicht-sensitive Sensorachse) von einem Messfeld (waagrecht zum Sensor, sensitive Sensorachse).

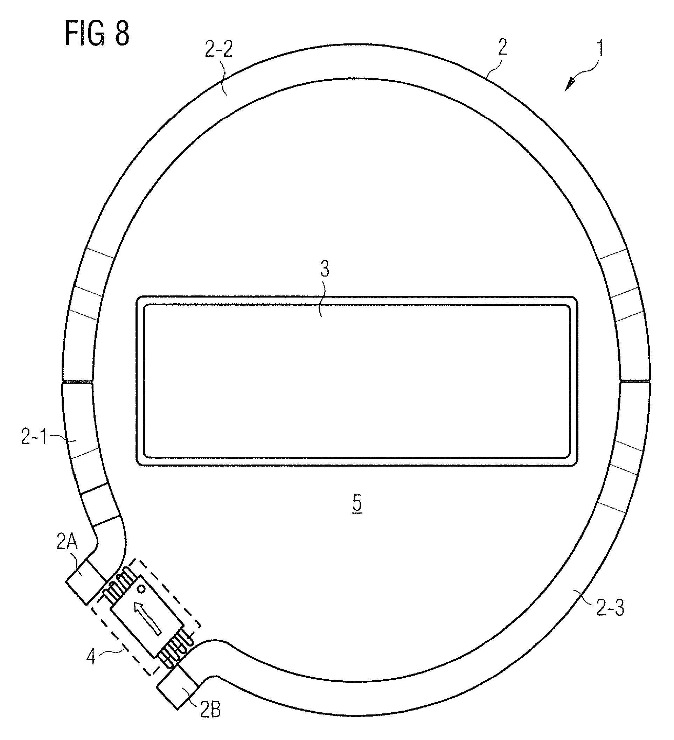

Fig. 8 zeigt schematisch eine Ansicht auf ein Ausführungsbeispiel der erfindungsgemäßen Vorrichtung 1 zur berührungslosen Strommessung. In Fig. 2 ist der Magnetfeldschirm 2 bei dem dargestellten Ausführungsbeispiel rohrschellenförmig ausgebildet und besitzt drei Schirmteile 2-1, 2-2, 2-3. Der Magnetfeldschirm 2 besitzt zwei Endabschnitte 2A, 2B, die einen Spaltbereich 4 definieren, in dem ein magnetoresistiver Sensor 6 angeordnet ist. Der rohrschellenförmig ausgebildete Magnetfeldschirm 2 umschließt einen Innenraum 5, in dem mindestens ein Stromleiter 3 angeordnet ist. Bei dem in Fig. 8 ausgeführten Ausführungsbeispiel umschließt der Magnetfeldschirm 2 einen Stromleiter 3 mit rechteckförmigem Querschnitt. Bei dem Stromleiter 3 kann es sich beispielsweise um eine Schiene, insbesondere eine Stromsammelschiene, handeln.

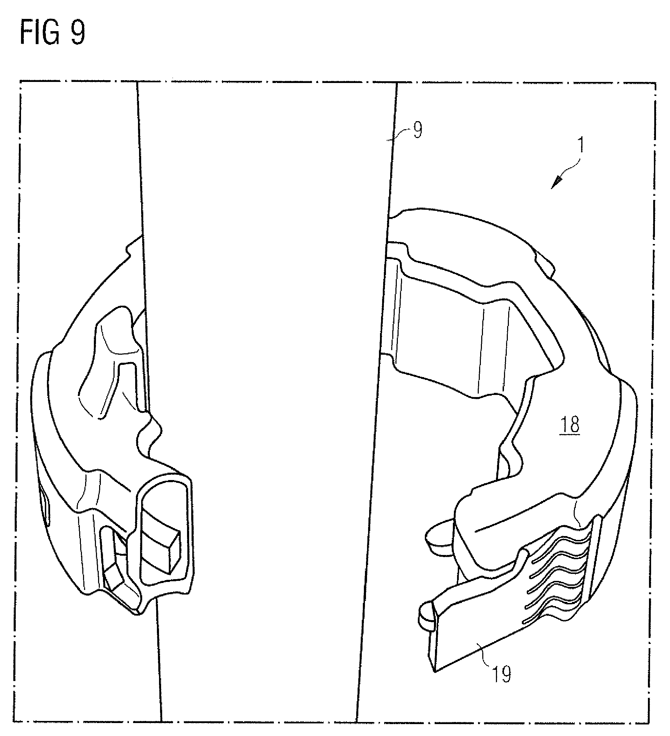

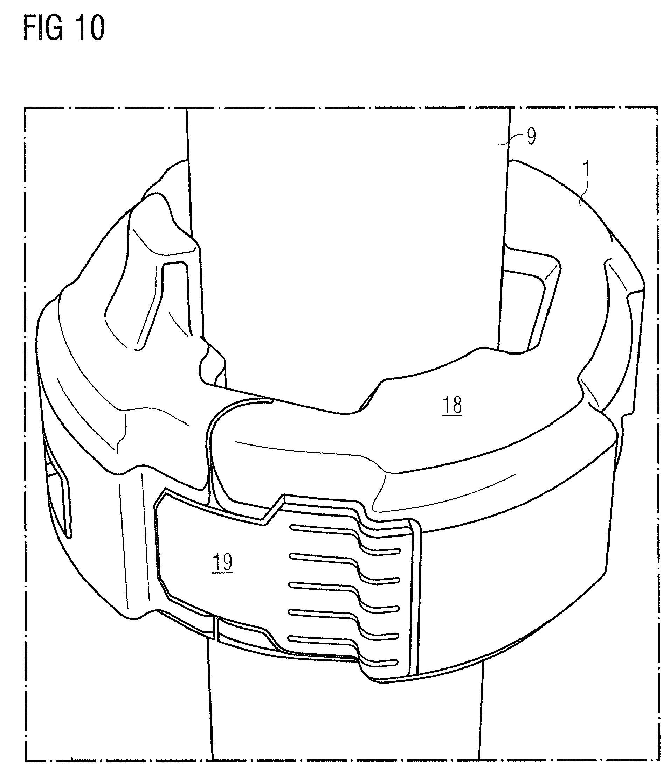

Bei einer möglichen Ausführungsform sind die Schirmteile 2-i des Magnetfeldschirms 2 eng miteinander verbunden und erlauben ein Aufrasten des Magnetfeldschirms 2 auf eine vorhandene Schiene, insbesondere Stromsammelschiene, wie in Fig. 9 dargestellt. Der Magnetfeldschirm 2, welcher aus einem amorphen Metall mit hoher Permeabilität und niedriger Remanenz bestehen kann, ist beispielsweise ringförmig ausgebildet. Dabei kann der ringförmig ausgebildete Magnetfeldschirm 2 innerhalb eines Kunststoffgehäuses 18 enthalten sein. Das Kunststoffgehäuse 18 kann für den jeweiligen Anwendungsfall symmetrisch ausgeformt sein. Bei dem in Fig. 9 dargestellten Ausführungsbeispiel ist das Kunststoffgehäuse 18, in welchem sich der ringförmige Magnetfeldschirm 2 mit seinen gelenkig verbundenen Magnetfeldschirmteilen befindet, derart ausgeformt, dass die Strommessvorrichtung 1 auf eine Sammelschiene 9 aufsetzbar und anschließend aufrastbar ist. Bei einer möglichen Ausführungsform ist die Kontur des Kunststoffgehäuses 18 derart ausgebildet, dass die Strommessvorrichtung 1 sowohl auf einen Rundleiter (beispielsweise mit einem Querschnitt von bis zu 300 mm²) als auch für eine Stromsammelschiene (beispielsweise bis zu 30 x 4 mm) nachträglich montierbar ist. Das in Fig. 9 dargestellte Strommessmodul ist vorzugsweise universell einsetzbar und nicht gerätegebunden. Die Strommessvorrichtung 1 kann auch in einer Anlage im laufenden Betrieb montiert werden, ohne den durch die Schiene 9 hindurchfließenden Stromfluss unterbrechen zu müssen. Bei der in Fig. 9 dargestellten Ausführungsform ist diese klappbar auf einen Stromleiter 3 bzw. eine Stromschiene aufsetzbar und dort montierbar. Bei einer bevorzugten Ausführungsform besitzt die Strommessvorrichtung 1 einen Verschlussmechanismus 19, sodass die Strommessvorrichtung nach Aufsetzen auf die Stromsammelschiene 9 fest montiert ist. Der Verschlussmechanismus 19 ist derart ausgebildet, dass er anschließend wieder gelöst werden kann, um die Strommessvorrichtung 1 von dem Stromleiter 3 bzw. der Stromsammelschiene 9 zu entfernen. Fig. 9 zeigt das Aufsetzen der Strommessvorrichtung 1 auf eine Stromsammelschiene 9 vor Schließen des Verschlussmechanismus 19. Demgegenüber zeigt Fig. 10 die klappbare Strommessvorrichtung 1 nach Aufsetzen auf der Stromsammelschiene 9 und erfolgter Schließung des Verschlussmechanismus 19. Wie man in Fig. 10 erkennen kann, besitzt das Gehäuse 18 der klappbaren Strommessvorrichtung 1 eine geometrische Form, die an die Stromsammelschiene 9 angepasst sein kann. Bei einer möglichen Ausführungsform ist der Verschlussmechanismus 19 ähnlich wie bei einem Skischuh auf den Stromsammelschienen 9 oder Stromleiter 3 verschiedener Größen aufrastbar und kann an die Größe des Stromleiters 3 angepasst werden. Nach Aufrasten und Schließen des Verschlussmechanismus 19 sitzt die klappbare Strommessvorrichtung 1 vorzugsweise fest auf der Stromsammelschiene 9. Nach Lösen des Verschlussmechanismus 19 kann die klappbare Strommessvorrichtung 1 in Längsrichtung der Schiene 9 an eine andere Stelle bewegt werden und anschließend wieder geschlossen werden. Alternativ kann der Verschlussmechanismus 19 vollständig geöffnet werden und die klappbare Strommessvorrichtung 1 an eine andere Schiene des Stromsammelschienensystems zur Messung des dort fließenden Stromes aufgesetzt und montiert werden.

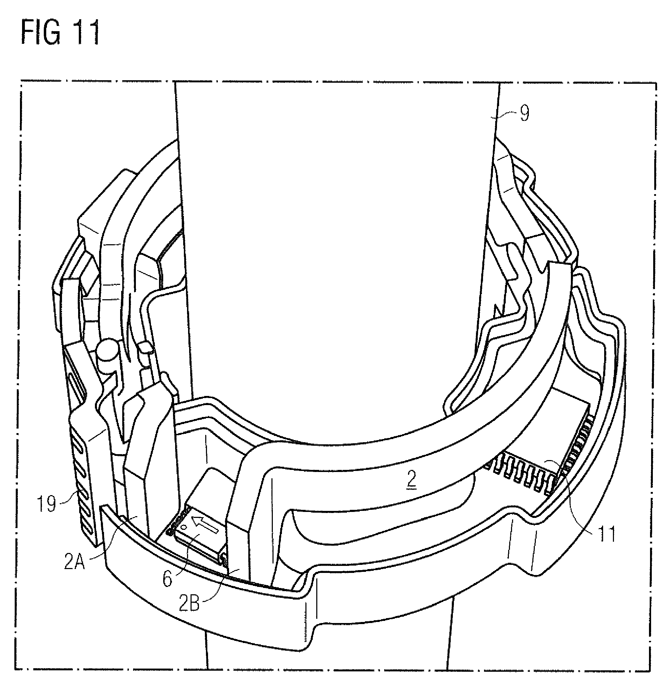

Fig. 11 zeigt die klappbare Strommessvorrichtung 1 mit teilweise geöffnetem Gehäuse 18. Man erkennt den innerhalb des Gehäuses 18 vorhandenen rohrschellenförmigen Magnetfeldschirm 2 mit seinen beiden Endabschnitten 2A, 2B, die einen Spaltbereich 4 definieren. In diesem Spaltbereich 4 befindet sich der magnetoresistive Sensor 6. Weiterhin befindet sich in dem von dem Magnetfeldschirm 2 umschlossenen Raum ein Mikrocontroller 11 zur Signalauswertung eines von dem magnetoresistiven Sensor 6 abgegebenen Messsignals. Der Magnetfeldschirm 2 ist vorzugsweise derart ausgebildet, dass er den Mikrocontroller 11 vor externen Störfeldern und einer zu hohen Feldbelastung durch das von dem mindestens einen Stromleiter 3 erzeugte Magnetfeld schützt.

Bei einer möglichen Ausführungsform ist der Magnetfeldschirm 2 aus mehreren Magnetfeldschirmteilen 2-i aufgebaut, die gelenkig miteinander verbunden sein können. Dabei kann die Form des Magnetfeldschirms 2 je nach Anwendungsfall variieren.

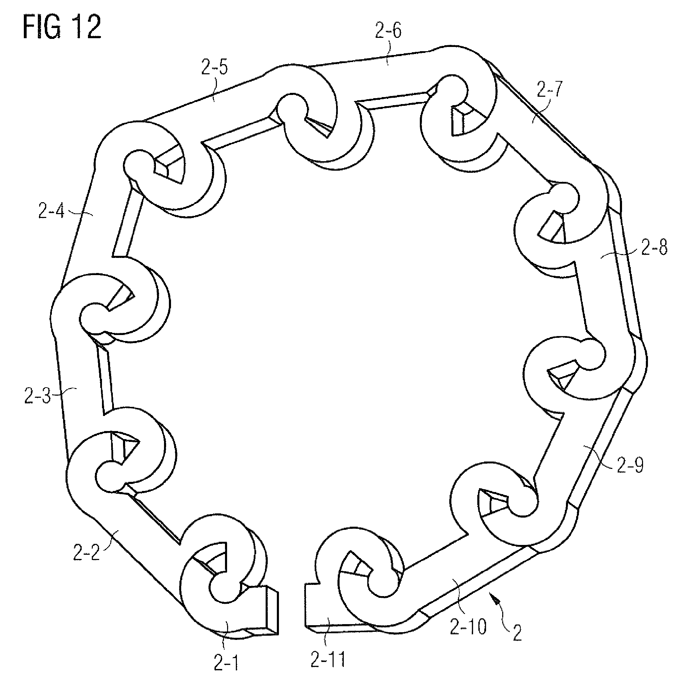

Fig. 12 zeigt beispielsweise einen Magnetfeldschirm 2 mit mehreren gelenkig miteinander verbundenen Magnetfeldschirmteilen 2-i. Bei dem in Fig. 12 dargestellten Ausführungsbeispiel besitzt der Magnetfeldschirm 2 elf Magnetfeldschirmteile 2-1 bis 2-11, die gelenkig miteinander verbunden sind. Der in Fig. 12 dargestellte Magnetfeldschirm 2 kann in einem elektrisch isolierenden Gehäuse 18 integriert sein, welches über einen Verschlussmechanismus 19 verfügt. Der Magnetfeldschirm 2 umschließt den Stromleiter 3 annähernd vollständig. Die Positionierung des magnetoresistiven Sensors 6 ist in einem Spaltbereich 4 vorgesehen. Dieser Spaltbereich 4 dient der Feldlinearisierung und Feldhomogenisierung. In dem Spaltbereich 4 erfasst der magnetoresistive Sensor 6 das für die Messung relevante Magnetfeld und ist dort bestmöglich vor Fremdfeldeinwirkungen geschirmt.

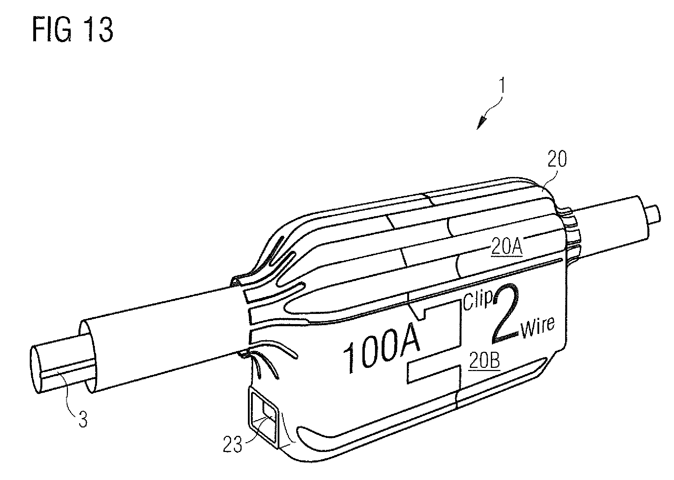

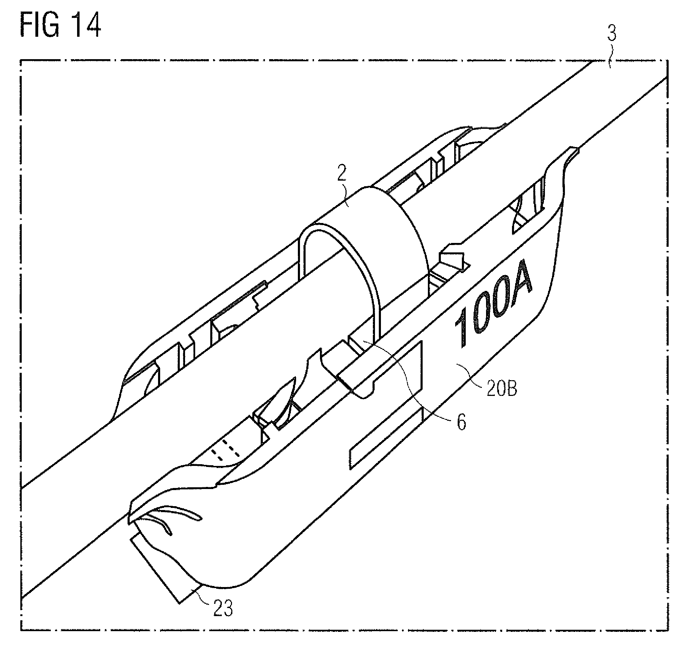

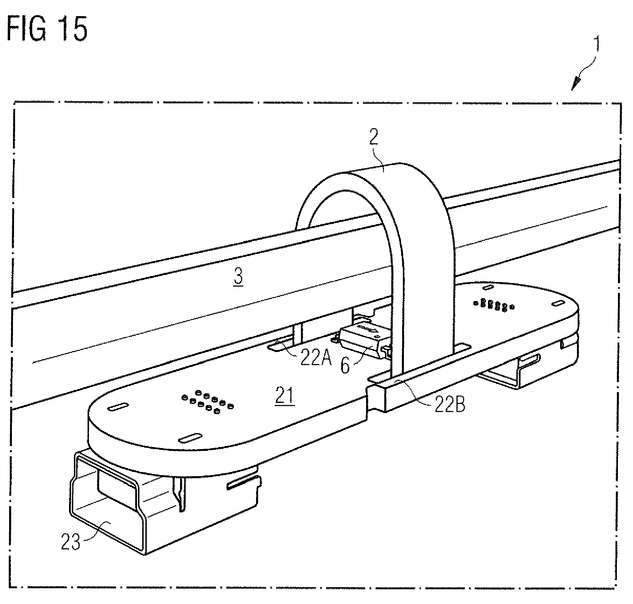

Fig. 13 zeigt eine weitere Ausführungsvariante der erfindungsgemäßen Vorrichtung 1 zur berührungslosen Strommessung. In der dargestellten Ausführungsvariante weist die Strommessvorrichtung 1 ein elektrisch isolierendes Kunststoffgehäuse 20 auf, das aus zwei Gehäuseschalen 20A, 20B besteht. Fig. 14 zeigt perspektivisch eine Ansicht auf die Strommessvorrichtung 1 gemäß Fig. 13 nach Abnahme der oberen Gehäuseschale 20A. Man erkennt in Fig. 14 einen Magnetfeldschirm 2, der den ggf. mit einem Isolationsmantel umgebenden Stromleiter 3 u-förmig umschließt. In dem Spaltbereich 4 des u-förmigen Magnetfeldschirms 2 befindet sich ein magnetoresistiver Sensor 6, wie in Fig. 14 erkennbar. Fig. 15 zeigt die in den Figuren 13, 14 dargestellte Ausführungsvariante der erfindungsgemäßen Strommessvorrichtung 1 nach Abnahme beider Gehäuseschalen 20A, 20B. Der GMR-Sensor 6 befindet sich auf einem Kunststoffträger 21 mit Schlitzen 22A, 22B, in welche die distalen Endabschnitte 2A, 2B des u-förmigen Magnetfeldschirms 2 einführbar sind. Die in den Figuren 13, 14, 15 dargestellte Ausführungsvariante erlaubt somit ebenfalls eine nachträgliche Montage auf eine bereits bestehende Stromleitung bzw. einen bereits bestehenden Strompfad, ohne den zu messenden Stromfluss unterbrechen zu müssen. Daher kann eine bestehende Anlage bzw. ein bestehendes Stromversorgungssystem im laufenden Betrieb nachträglich mit einer erfindungsgemäßen Strommessvorrichtung 1 zur Strommessung versehen werden. Die Strommessvorrichtung 1, wie sie in der Ausführungsvariante gemäß Figuren 14, 15, 16 dargestellt ist, ist nicht gerätegebunden und kann beispielsweise für alle stromführenden Leiter mit geeignetem Querschnitt (beispielsweise bis zu 16 mm²) zur Messung eines Stromes I (beispielsweise bis zu 100 A AC) eingesetzt werden. Die erfindungsgemäße Strommessvorrichtung 1 kann dabei sowohl Gleich- als auch Wechselstrom messen. Beispielsweise kann die Strommessvorrichtung 1 derart ausgebildet sein, dass sie einen Gleichstrom bis 150 Ampere und einen Wechselstrom bis 100 Ampere misst. Bei einer möglichen Ausführungsform liegt der Stromleiter 3 in flexiblen Führungen des Gehäuses 20, die sich auf verschiedene Kabel bzw. Stromleiterquerschnitte einstellen können und somit eine mittige Platzierung des Stromleiters 3 innerhalb des Gehäuses 20 gewährleisten. Bei der in den Figuren 14, 15, 16 dargestellten Ausführungsvariante kann der Magnetfeldschirm 2 in der oberen Gehäuseschale 20A des Gehäuses 20 eingegossen sein und bei Montage der Strommessvorrichtung 1 auf den Stromleiter 3 in die beiden Schlitze 22A, 22B der Trägerplatte 21 eingeführt werden. Der auf der Trägerplatte 21 vorgesehene magnetsresistive Sensor 6 liefert ein analoges Messsignal. Bei einer möglichen Ausführungsvariante kann in der Trägerplatte 21 ein Mikrocontroller 11 integriert sein, welcher über eine Datenschnittstelle 23 mit einer externen Steuerung der Anlage kommuniziert und/oder Steuersignale an einen oder mehrere Aktoren 13 der betreffenden Anlage generiert.

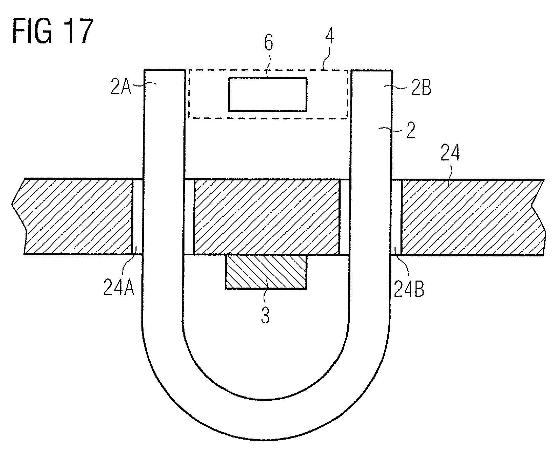

Figuren 16, 17 zeigen weitere Ausführungsvarianten der erfindungsgemäßen Vorrichtung 1 zur berührungslosen Strommessung. Bei den in den Figuren 16, 17 dargestellten Ausführungsformen ist der Stromleiter 3 eine auf einer Platine 24 verlaufende Leiterbahn. Bei der in Figur 16 dargestellten Ausführungsform ist der Magnetfeldschirm 2 u-förmig bzw. rohrschellenförmig ausgebildet und besitzt zwei Endabschnitte 2A, 2B, die einen Spaltbereich 4 definieren. In dem Spaltbereich 4 befindet sich ein magnetoresistiver Sensor 6, beispielsweise ein GMR-Sensor. Die Platine 24 besitzt bei der dargestellten Ausführungsform zwei Öffnungen 24A, 24B, durch welche der rohrschellenförmige Magnetfeldschirm 2 durchgeführt wird, wobei er auf der unteren Seite der Leiterplatine 24 die Leiterbahn 3 umschließt und wobei die beiden Endabschnitte 2A, 2B des Magnetfeldschirms 2 auf der oberen Seite der Leiterplatine 24 dem offenen Spaltbereich 4 definieren, in dem der magnetoresistive Sensor 6 angeordnet ist. Fig. 17 zeigt eine weitere Ausführungsvariante der erfindungsgemäßen Strommessvorrichtung 1, bei einem auf einer Leiterplatine 24 angebrachten Stromleiter 3. Bei der in Fig. 17 dargestellten Ausführungsform ist der Magnetfeldschirm 2 u-förmig ausgebildet, wobei die beiden Schenkel des u-förmig ausgebildeten Magnetfeldschirms 2 durch zwei entsprechende Öffnungen 24A, 24B der Leiterplatine 24 hindurchgeführt sind und die Endabschnitte der beiden Schenkel den offenen Spaltbereich 4 definieren, in welchem sich der magnetoresistive Sensor 6 befindet. Bei den in den Figuren 16, 17 dargestellten Ausführungsformen befindet sich der Stromleiter 3 auf der unteren Seite der Leiterplatine 24, während sich der magnetoresistive Sensor 6 auf der entgegengesetzten oberen Seite der Leiterplatine 24 befindet. Der Stromleiter 3 besteht beispielsweise aus einer stromleitenden Kupferbahn. Die Kupferbahn selbst wird von dem u-förmigen Magnetfeldschirm 2 umschlossen, wobei die Magnetfeldlinien MFL entlang der Sensitivitätsachse des magnetoresistiven Sensors 6 verlaufen. Durch eine mechanische Fixierung kann der Magnetfeldschirm 2 in eine Kunststoffhalterung gepresst werden. Bei den in den Figuren 16, 17 dargestellten Ausführungsformen befindet sich der Stromleiter 3 auf einer Seite der Platine 24. Bei einer alternativen Ausführungsform kann der Stromleiter 3 auch innerhalb der Leiterplatine 24 integriert verlaufen. Ein Vorteil der in den Figuren 16, 17 dargestellten Ausführungsform besteht darin, dass die erfindungsgemäße Strommessvorrichtung 1 angebracht werden kann, ohne dass der Stromfluss durch die Stromleiterbahn 3 unterbrochen werden muss. Bei Verwendung der erfindungsgemäßen Strommessvorrichtung 1 muss somit keine Auftrennung des Strompfades bzw. Stromkreises auf der Platine erfolgen. Die in den Figuren 16, 17 dargestellte Ausführungsform zur Anwendung bei einer Platine ermöglicht eine besonders platzsparende Integration der Strommesseinheit 1 für eine Platine eines Schaltgerätes. Die Vorrichtung 1 zur berührungslosen Strommessung, wie sie in den Ausführungsbeispielen gemäß Figuren 16, 17 dargestellt ist, ermöglicht zudem sowohl die Messung eines Gleichstromes DC als auch die Messung eines Wechselstromes AC oder eines Stromsignales, welches auf einer Leiterbahn einer Platine 24 des Gerätes fließt. Die Öffnungen 24A, 24B werden vorzugsweise bereits bei der Herstellung der Leiterplatine hergestellt, beispielsweise an vorgegebenen Messpunkten. Weiterhin können Strommessvorrichtungen 1 entweder temporär oder dauerhaft an den verschiedenen Messpunkten der Leiterplatine 24 angebracht werden. Insbesondere die in Fig. 17 dargestellte Ausführungsform mit einem u-förmigen Magnetfeldschirm 2 erlaubt es, die beiden Schenkel des Magnetfeldschirms 2 nachträglich durch bereits vorhandene Öffnungen 24A, 24B hindurchzuführen, um eine Strommessvorrichtung 1 vorübergehend oder dauerhaft an der Leiterplatine 24 zur Strommessung anzubringen.

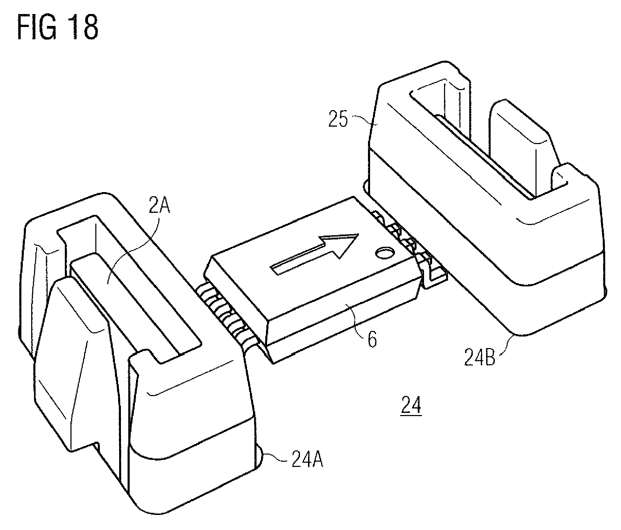

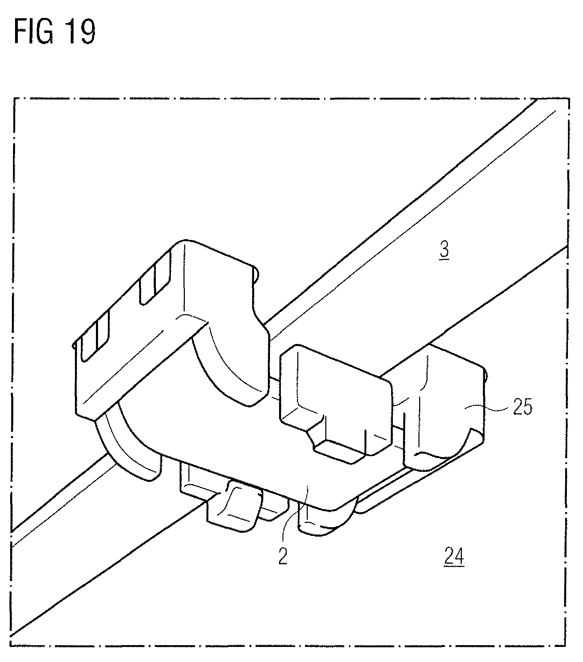

Bei einer möglichen Ausführungsform weist die Strommessvorrichtung 1 zur Anwendung bei Leiterplatinen eine Kunststoffhalterung 25 auf. Durch die mechanische Fixierung der austauschbaren bzw. nachrüstbaren Strommessvorrichtung 1 wird der Magnetfeldschirm 2 in die vorhandene Kunststoffhalterung 25 gedrückt bzw. gepresst. Fig. 18 zeigt die Oberseite einer Leiterplatine 24 mit einer darin vorgesehenen Kunststoffhalterung 25, in welche die beiden Endabschnitte 2A, 2B des u-förmigen Magnetfeldschirms 2 zur mechanischen Fixierung gedrückt werden. Fig. 19 zeigt die Unterseite der entsprechenden Leiterplatine 24 und der Kunststoffhalterung mit dem Basisabschnitt des u-förmigen Magnetfeldschirms 2. Der u-förmige Magnetfeldschirm 2 umschließt die auf der Unterseite der Platine 24 verlaufende Leiterbahn 3, wie in Fig. 19 dargestellt.

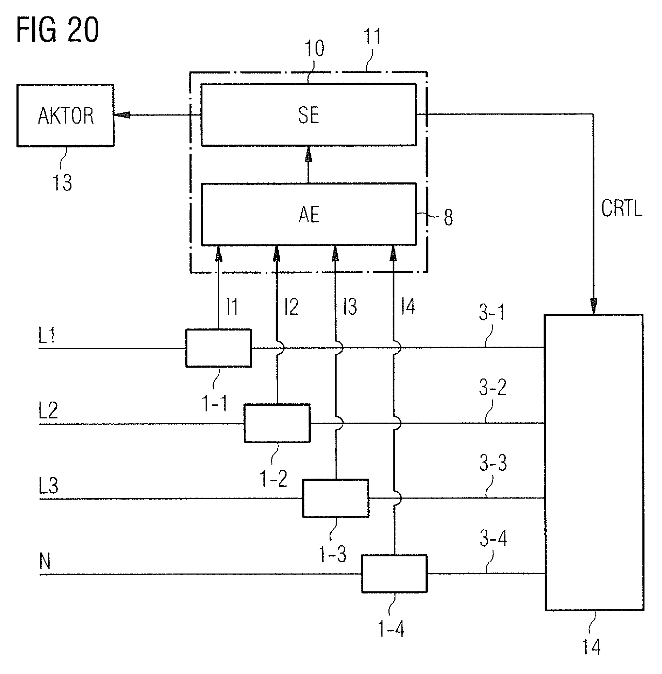

Fig. 20 zeigt eine Schaltanordnung, bei der mehrere erfindungsgemäße Strommessvorrichtungen 1 zur berührungslosen Strommessung verwendet werden. Bei der in Fig. 20 dargestellten Schaltanordnung wird eine Last bzw. ein Gerät 14 mit Stromphasen eines Mehrphasen-Stromversorgungsnetzes mit Strom versorgt. Das Stromversorgungsnetz weist drei Phasen L1, L2, L3 auf sowie einen Nullleiter N. Das Gerät bzw. die Last 14 ist über Stromversorgungsleitungen 3-1, 3-2, 3-3 sowie den Nullleiter 3-4 mit dem Stromversorgungsnetz verbunden. Bei dem in Fig. 2 dargestellten Anwendungsbeispiel ist an jeder Stromleitung 3-i eine erfindungsgemäße Strommessvorrichtung 1 zur berührungslosen Strommessung vorgesehen bzw. montiert. Eine Strommessvorrichtung 1 kann auch an weitere Leitungen, beispielsweise einem PE-Leiter, vorgesehen werden. Diese Strommessvorrichtungen 1-i können auch nachträglich an die bereits vorhandene entsprechende Stromversorgungsleitung 3-i angebracht werden, ohne die Stromversorgung für die Last bzw. das Gerät 14 zu unterbrechen. Die Strommessvorrichtungen 1-i liefern Strommesswerte bzw. Stromsignale I-1, I-2, I-3, I-4 bei dem dargestellten Ausführungsbeispiel an eine Auswerteeinheit 8, welche die Strommesswerte auswertet und die Auswerteergebnisse einer Steuereinheit 10 zur Verfügung stellt. Die Auswerteeinheit 8 und die Steuereinheit 10 sind beispielsweise in einem Mikroprozessor 11 oder einer sonstigen Datenverarbeitungseinheit integriert. Die Steuereinheit 10 kann in Abhängigkeit von dem erhaltenen Auswerteergebnis beispielsweise einen oder mehrere Aktoren 13 der Anlage oder das versorgte Gerät 14 selbst ansteuern, beispielsweise durch Veränderung von Geräteparametern des Gerätes 14. Eine Stromphase L_{X} kann auch über mehrere parallele Leitungen 3-i fließen, die von dem Magnetfeldschirm 2 der Strommessvorrichtung 1 umschlossen sind.

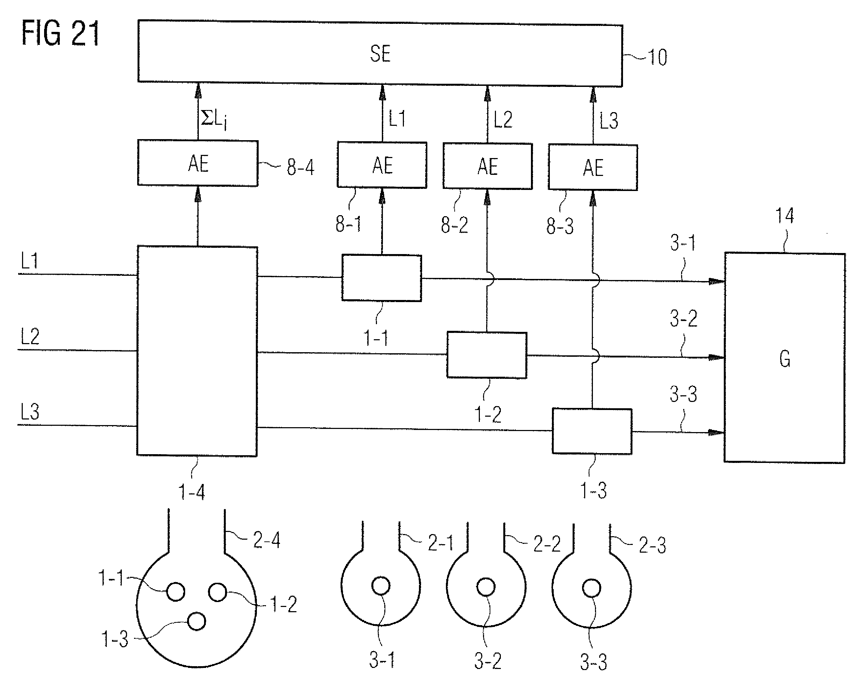

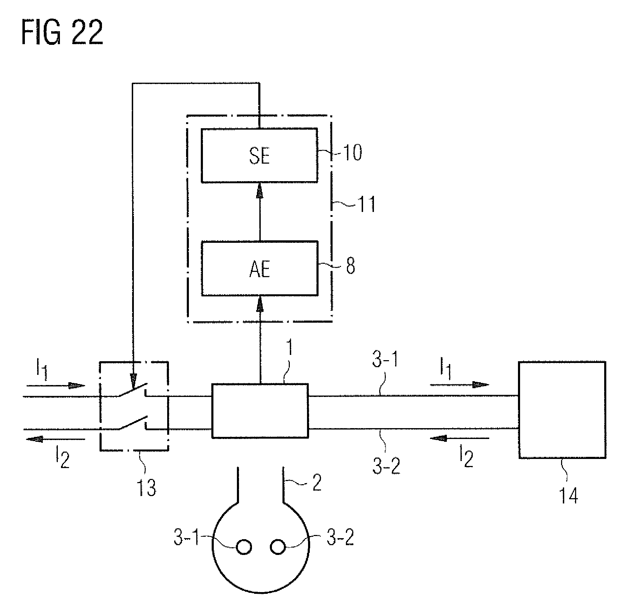

Fig. 21 zeigt ein weiteres Anwendungsbeispiel für eine Anlage, die Strommessvorrichtungen 1 zur berührungslosen Strommessung gemäß der Erfindung verwendet. Bei der in Fig. 21 dargestellten Anlage wird eine Last bzw. ein Gerät 14 an drei Stromphasen L1, L2, L3 über Stromversorgungsleitungen 3-1, 3-2, 3-3 mit Strom versorgt. An jeder der drei Stromversorgungsleitungen 3-i ist eine Strommessvorrichtung 1-i vorgesehen, welche Strommesssignale bzw. Strommesswerte an eine zugehörige Auswerteeinheit 8-i liefern. Wie in Fig. 1 graphisch angedeutet, umschließen Magnetfeldschirme 2-i der jeweiligen Strommesseinrichtungen 1-i einen einzelnen Leiter 3-i, um den darin fließenden elektrischen Strom L-i zu messen. Für eine Stromphase L-i können auch mehrere parallele Stromleiter vorgesehen sein. Darüber hinaus weist die Schaltanordnung gemäß Fig. 21 eine Summenstrommessvorrichtung 1-4 auf. Diese Summenstrommessvorrichtung hat einen Magnetfeldschirm 2-4, welche alle drei Stromversorgungsleitungen 1-1, 1-2, 1-3 umschließt, wie in Fig. 21 graphisch angedeutet. Die Auswerteeinheit 8-4 wertet das von dem magnetoresistiven Sensor 6 der Summenstrommessvorrichtung 1-4 gemessene Signal aus, welches dem Summenstrom der drei Stromphasen L1, L2, L3 entspricht. Bei dem in Fig. 21 dargestellten Ausführungsbeispiel sind die verschiedenen Auswerteeinheiten 8-i mit einer gemeinsamen zentralen Steuereinheit 10 verbunden, welche Aktoren 13 der Anlage sowie das Gerät 14 in Abhängigkeit des gemessenen Summenstromes sowie der in den verschiedenen Stromleitungen 3-i gemessenen einzelnen Stromphasen L1, L2, L3 ansteuern kann. Bei einer möglichen Ausführungsform der erfindungsgemäßen Strommessvorrichtung 1 ist der Magnetfeldschirm 2 derart ausgebildet, dass er geeignet ist, entweder eine Stromleitung, zwei Stromleitungen oder mehrere Stromleitungen gleichzeitig zu umschließen. Bei dieser Ausführungsform kann die Strommessvorrichtung 1 sowohl als Summenstrommessvorrichtung eingesetzt werden als auch als Einzelstrommessvorrichtung. Beispielsweise kann eine derartige Strommessvorrichtung 1 auch geeignet sein, zwei Stromleitungen zu umschließen, um deren Ströme zu messen. Bei dieser Ausführungsform ist die Strommessvorrichtung 1 somit flexibel für verschiedene Anwendungsfälle einsetzbar. Bei der in Fig. 21 dargestellten Schaltanordnung können die verschiedenen Strommessvorrichtungen 1-i entweder permanent fest an die vorhandenen Stromleitungen montiert werden oder zeitweise. Bei einer möglichen Ausführungsform erfolgt die Signalübertragung von der Strommessvorrichtung 1-i zu der zugehörigen Auswerteeinheit 8-i drahtlos über eine Funkschnittstelle. Hierzu weisen die verschiedenen Strommessvorrichtungen 1-i jeweils einen Transmitter bzw. Transceiver zur Messsignalübertragung auf. Fig. 22 zeigt ein weiteres Ausführungsbeispiel der erfindungsgemäßen Strommessvorrichtung zur berührungslosen Strommessung. Bei der in Fig. 22 dargestellten Ausführungsform umschließt der Magnetfeldschirm 2 zwei Stromleitungen 3-1, 3-2, an die eine Last 14 angeschlossen ist. Über den ersten Stromleiter 3-1 fließt ein Hinstrom I1 und über den zweiten Stromleiter 3-2 ein Rückstrom I2. Beide Stromleiter 3-1, 3-2, werden durch den Magnetfeldschirm 2 umschlossen, in dessen Spaltbereich ein magnetoresistiver Sensor 6 vorgesehen ist, der Messsignale an die Auswerteeinheit 8 der Vorrichtung 1 liefert. Die Strommessvorrichtung 1 misst den Differenzstrom zwischen dem Hin- und Rückstrom. Überschreitet die Differenz zwischen Hin- und Rückstrom einen gewissen Schwellenwert, wird durch die Steuereinheit 10 ein in dem Stromkreis enthaltener Aktor, insbesondere eine Schalteinheit 13, automatisch geöffnet, um den Stromkreis zu unterbrechen. Bei der in Fig. 22 dargestellten Ausführungsvariante sind die beiden parallel angeordneten Stromleiter 3-1, 3-2 antiparallel von zwei verschiedenen elektrischen Strömen I1, I2, insbesondere von einem Hin- und Rückstrom, durchflossen, wobei der magnetoresistive Sensor 6 eine Differenzstromstärke zwischen den Stromstärken der beiden elektrischen Ströme I1, I2 berührungslos erfasst. Die Auswerteeinheit 8 wertet die gemessene Differenzstromstärke aus. Die Steuereinheit 10 steuert in Abhängigkeit von der Differenzstromstärke den Aktor 13 an, indem sie ihn bei Überschreitung eines vorgegebenen einstellbaren Schwellenwertes automatisch öffnet.

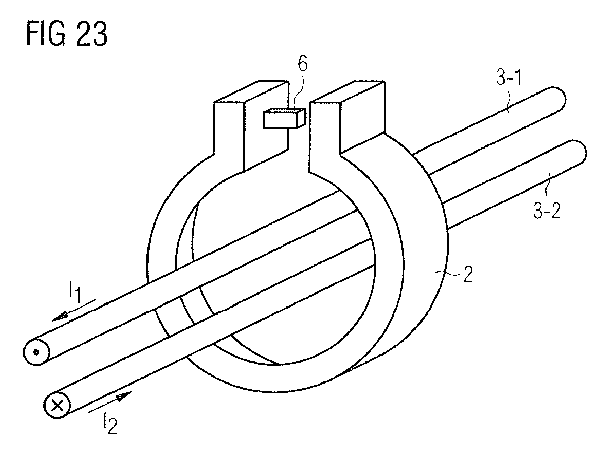

Fig. 23 zeigt schematisch den Magnetfeldschirm 2 der Strommesseinrichtung 1 für die in Fig. 22 dargestellte Strommessvorrichtung. Die beiden Stromleitungen 3-1, 3-2 für den Hinund Rückstrom verlaufen im Wesentlichen parallel zueinander, insbesondere im Bereich des sie umschließenden Magnetfeldschirms 2.

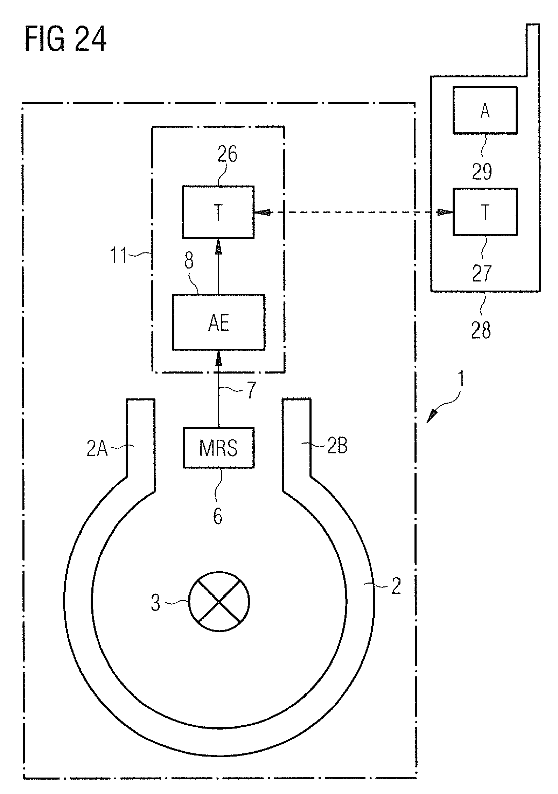

Fig. 24 zeigt eine weitere Ausführungsform der erfindungsgemäßen Strommessvorrichtung 1 zur berührungslosen Strommessung. Bei dem in Fig. 24 dargestellten Ausführungsbeispiel verfügt der Mikroprozessor 11 über einen Transceiver bzw. Transmitter 26. Das von der Auswerteeinheit 8 gelieferte Messergebnis wird von dem Transmitter 26 über eine drahtlose Schnittstelle an einen Transceiver bzw. Receiver 27 eines mobilen Endgerätes 28 übertragen, welches über eine Anzeigeeinheit 29 verfügt. Bei dem mobilen Endgerät 28 handelt es sich beispielsweise um ein Mobilfunkgerät bzw. Handy. Bei der drahtlosen Funkverbindung handelt es sich beispielsweise um eine NFC-Funkverbindung oder eine Blue Tooth-Verbindung. Der Transceiver 26 überträgt bei einer möglichen Ausführungsform die gemessenen Stromwerte des durch den Leiter 3 hindurchfließenden elektrischen Stromes I drahtlos zu dem Transceiver 27 des Mobilfunkgerätes 28 eines Nutzers. Die übertragenen Stromwerte werden auf der Anzeigeeinheit bzw. dem Display des Mobilfunkgerätes 28 dem Nutzer angezeigt.

Bei einer weiteren Ausführungsvariante weist die erfindungsgemäße Strommessvorrichtung 1 eine mechanische Einrichtung zum Aufrasten des Magnetfeldschirms 2 auf die mindestens eine zu messende Stromleitung 3 auf. Dabei kann der Magnetfeldschirm 2 auf eine oder mehrere Stromleiter 3 unterschiedlichen Querschnitts und unterschiedlicher Querschnittsform aufgerastet werden. Bei einer möglichen Ausführungsvariante wird beim Aufrasten zusätzlich der Querschnitt des betreffenden Stromleiters 3 erfasst bzw. erkannt und daraus abgeleitet, welche Soll-Stromstärke durch den betreffenden Stromleiter innerhalb der Anlage im Normalbetrieb zu fließen hat. Bei einer möglichen Ausführungsform wird der Querschnitt und/oder die Art bzw. der Typ des ausgemessenen Stromleiters 3 an das Mobilfunkgerät 28 des Nutzers übertragen und auf dessen Anzeigeeinheit 29 angezeigt. Beispielsweise kann auf der Anzeigeeinheit angezeigt werden, dass der momentan ausgemessene Stromleiter einen Querschnitt von 16 mm² aufweist, durch den eine Soll-Stromstärke AC von beispielsweise 100 Ampere oder eine Gleichstromstärke DC von beispielsweise 150 Ampere Nennstrom fließen soll. Bei einer möglichen Ausführungsform wird auf der Anzeigeeinheit 29 des tragbaren Gerätes 28 sowohl die gemessene aktuelle Stromstärke als auch die Soll-Stromstärke angezeigt. Weiterhin kann die Differenz zwischen der Soll-Stromstärke und der aktuellen gemessenen Stromstärke angezeigt werden.

Weitere Ausführungsvarianten der erfindungsgemäßen Strommessvorrichtung 1 zur berührungslosen Strommessung sind möglich. Bei einer weiteren bevorzugten Ausführungsvariante kann die Strommessvorrichtung 1 nach Aufsetzen auf der Stromleitung bzw. Stromschiene 3 mittels eines Schlittens entlang der Stromleitung 3 bewegt werden, um mehrere Strommessungen an verschiedenen bzw. Stellen der Stromleitung 3 nacheinander ausführen zu können. Bei einer möglichen Ausführungsform ist beispielsweise auf dem Mantel der Stromleitung 3 eine Codierung vorgesehen, um die aktuelle Position der Strommessvorrichtung 1 auf der Stromleitung zu bestimmen. Umfasst die Stromleitung bzw. die Stromschiene beispielsweise mehrere Meter Länge wird bei Verschiebung der Strommessvorrichtung 1 auf der Stromleitung bzw. Stromsammelschiene automatisch die Position der Strommessvorrichtung 1 bei der Vornahme der Strommessung durch eine Positionsdetektionseinheit der Strommessvorrichtung 1 erkannt. Bei einer weiteren speziellen Ausführungsvariante verfügt die Strommesseinrichtung 1 zusätzlich über eine Antriebseinheit, um die Strommessvorrichtung 1 mittels eines Schlittens auf der Stromsammelschiene 3 zur Vornahme von verschiedenen Strommessungen an verschiedenen Stellen zu bewegen.

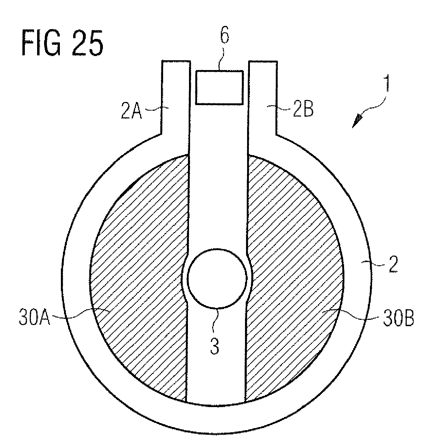

Fig. 25 zeigt eine weitere Ausführungsvariante der erfindungsgemäßen Strommessvorrichtung 1. Bei der in Fig. 25 dargestellten Ausführungsform sind in dem kreisförmigen Magnetfeldschirm 2 zwei halbkreisförmige Gummihäute oder Gummiringe 30A, 30B gespannt, um den Magnetfeldschirm 2 auf den Stromleiter 3 aufzusetzen. Die beiden Gummihäute oder Gummiringe 30A, 30B bestehen aus einem elastischen Material und erlauben ein einfaches Aufsetzen des Magnetfeldschirms 2 auf den zu messenden Stromleiter 3. Die in Fig. 25 dargestellte Ausführungsform eignet sich insbesondere für Stromleiter 3 mit geringerem Durchmesser, auf welche die Strommessvorrichtung 1 aufsetzbar ist.

Die erfindungsgemäße Strommessvorrichtung 1 kann gemäß einem weiteren Aspekt der Erfindung in einem separaten Strommessgerät, insbesondere einer Strommesszange, integriert sein. Dieses Strommessgerät kann einen durch den Stromleiter fließenden elektrischen Gleichstrom und/oder einen durch den Stromleiter fließenden elektrischen Wechselstrom messen. Bei einer möglichen Ausführungsvariante wird das Strommessgerät zwischen zwei Betriebsmodi manuell oder automatisch geschaltet, wobei in einem ersten Betriebsmodus ein durch den Stromleiter 3 fließender elektrischer Gleichstrom DC und in einem zweiten Betriebsmodus ein durch den Stromleiter 3 hindurchfließender Wechselstrom AC durch das Strommessgerät gemessen wird. Dieses Strommessgerät weist bei einer möglichen Ausführungsform eine integrierte Auswerteeinheit 8 zur Auswertung der gemessenen Stromstärke auf. Weiterhin verfügt das Strommessgerät vorzugsweise über eine Anzeigeeinheit zur Anzeige der an dem Stromleiter 3 gemessenen Stromstärke. Darüber hinaus kann das Strommessgerät auch über eine Sendeeinheit zur drahtlosen Übertragung der gemessenen Stromstärke an eine externe Empfangseinheit des mobilen Gerätes, beispielsweise eines Mobilfunkgerätes, verfügen.

Alternativ kann die erfindungsgemäße Strommessvorrichtung 1 fest an einen bereits bestehenden Stromleiter montiert und Strommesssignale an eine zentrale Steuerung der Anlage liefern. Die erfindungsgemäße Strommessvorrichtung 1 zeichnet sich durch einen sehr hohen Wirkungsgrad von nahezu 100 % aus, d.h. mit einer sehr geringen Verlustleistung. Eine bestehende Anlage kann mit einer oder mehreren erfindungsgemäßen Strommessvorrichtungen 1 nachgerüstet werden, ohne den Betrieb der Anlage unterbrechen zu müssen. Die erfindungsgemäße Strommessvorrichtung 1 weist einen magnetoresistiven Sensor 6 auf, der nur einen sehr geringen Platz innerhalb eines Spaltbereichs 4 benötigt. Dementsprechend kann die erfindungsgemäße Strommessvorrichtung 1 besonders platzsparend implementiert werden und benötigt insbesondere keine relativ großen Strommessspulen, insbesondere Rogowski-Spulen.

Bei einer weiteren möglichen Ausführungsvariante der erfindungsgemäßen Strommessvorrichtung 1 ist diese automatisch mittels eines vorgegebenen Referenzstromes, welcher von einer Referenzstromquelle der Strommessvorrichtung 1 geliefert wird, kalibrierbar. Bei dieser Ausführungsvariante kann der Magnetfeldschirm 2 eine zusätzliche Referenzstromleitung umschließen, durch welche der vorgegebene Referenzstrom IREF zur Kalibrierung der Strommessvorrichtung 1 fließt. Die Kalibrierung kann in einem weiteren Kalibrierbetriebsmodus erfolgen.

Bei einer weiteren möglichen Ausführungsform der erfindungsgemäßen Strommessvorrichtung 1 verfügt die auf die Stromleitung 3 aufgerastete Strommessvorrichtung 1 über eine eigene Anzeigeeinheit bzw. ein Display, um die gemessene Stromstärke einem Nutzer anzuzeigen. Die erfindungsgemäße Strommessvorrichtung 1 erlaubt eine berührungslose Strommessung mit einer hohen Messgenauigkeit. So kann das erfindungsgemäße Strommessgerät bzw. die Strommessvorrichtung 1 die Stromstärke von 100 Ampere mit einer Messgenauigkeit von unter 1 Ampere messen.

Die erfindungsgemäße Strommessvorrichtung 1 eignet sich sowohl für Summenstrommessung als auch für Differenzstrommessung. Bei einer weiteren möglichen Ausführungsvariante umschließt der Magnetfeldschirm 2 der Strommessvorrichtung 1 zwei Stromleitungen, durch die zwei verschiedene Ströme fließen. Bei einer möglichen Ausführungsform mittels einer Eingabeeinheit der Strommessvorrichtung bzw. des Strommessgerätes 1 zwischen einer Summenstrommessung und einer Differenzstrommessung umgeschaltet werden. Die erfindungsgemäße Strommessvorrichtung 1 eignet sich zur Messung verschiedener Stromsignale, insbesondere eines Gleichstromes, eines sinusförmigen Wechselstromes oder sonstiger Stromsignale, beispielsweise Dreiecksignale, Sägezahnsignale oder Rechtecksignale. Bei einer möglichen Ausführungsform wertet die Auswerteeinheit 8 der erfindungsgemäßen Strommessvorrichtung 1 Oberwellen des fließenden Stromes aus, um mögliche Betriebszustände des angeschlossenen Gerätes bzw. der zugehörigen Stromversorgungseinheit zu erkennen. Bei einer möglichen speziellen Ausführungsvariante ermittelt die Auswerteeinheit 8 ein lokales Frequenzspektrum des an die Last 14 zu übertragenen Normstromes.

Bei einer weiteren möglichen Ausführungsvariante der erfindungsgemäßen Strommesseinheit 1 verfügt der Mikroprozessor 11 über eine Datenschnittstelle zur Übertragung von Messdaten und Auswerteergebnissen an eine externe zentrale Steuerung der Anlage. Bei einer weiteren möglichen Ausführungsvariante verfügt die Strommessvorrichtung bzw. das Strommessgerät 1 über einen internen Signal- bzw. Datenspeicher zur Aufzeichnung der Auswerteergebnisse, welche über eine Datenschnittstelle auslesbar sind. Erkennt beispielsweise die Auswerteeinheit 8 einen kritischen oder auffälligen Zustand, können die Messsignale und/oder die Auswerteergebnisse für einen vorgegebenen Zeitraum in dem Datenspeicher des Messgerätes 1 aufgezeichnet werden, um anschließend eine genaue Analyse des möglichen Fehlerfalles vornehmen zu können.

## Patentansprüche

1. Vorrichtung (1) zur berührungslosen Strommessung mindestens eines durch einen Stromleiter (2) fließenden elektrischen Stromes (I) mit:
- einem Magnetfeldschirm (2), welcher den mindestens einen Stromleiter (3) bis auf einen Spaltbereich (4) umschließt und den umschlossenen Raum (5) vor externen Störfeldern abschirmt,
- wobei ein von dem Stromleiter (3) bei hindurchfließendem elektrischen Strom erzeugtes Magnetfeld in dem Spaltbereich (4) des Magnetfeldschirms linearisierte Feldlinien mit homogenisierter Feldstärke aufweist und
- mit mindestens einem magnetoresistiven Sensor (6), der in dem Spaltbereich (4) angeordnet ist und das dort bestehende linearisierte und homogenisierte Magnetfeld, dessen Feldstärke der Stromstärke des durch den Stromleiter (3) fließenden elektrischen Stromes (I) entspricht, erfasst.

2. Vorrichtung nach Anspruch 1,
wobei der Magnetfeldschirm (2) den Stromleiter (3) u-förmig oder nahezu ringförmig umschließt.

3. Vorrichtung nach Anspruch 1 oder 2,
wobei der Magnetfeldschirm (2) mehrere Schirmteile aufweist.

4. Vorrichtung nach Anspruch 3,
wobei die Schirmteile des Magnetfeldschirms (2) gelenkig miteinander verbunden sind und den Stromleiter (3) umschließen.

5. Vorrichtung nach Anspruch 2,
wobei der u-förmige Magnetfeldschirm (2) zwei gegenüberliegende Schenkel aufweist, wobei sich zwischen den beiden parallel verlaufenden Schenkeln der offene Spaltbereich (4) des Magnetfeldschirms (2) befindet.

6. Vorrichtung nach Anspruch 2,
wobei der den Stromleiter (3) nahezu ringförmig umschließende Magnetfeldschirm (2) rohrschellenförmig ausgebildet ist.

7. Vorrichtung nach Anspruch 6,
wobei die beiden Endabschnitte (2A, 2B) des rohrschellenförmig ausgebildeten Magnetfeldschirms (2) nach außen gebogen sind und zueinander parallel verlaufen, wobei sich zwischen den beiden Endabschnitten (2A, 2B) der offene Spaltbereich (4) des Magnetfeldschirms (2) befindet.

8. Vorrichtung nach einem der Ansprüche 1 bis 7,
wobei der magnetoresistive Sensor (6) einen GMR-Sensor, einen TMR-Sensor, einen AMR-Sensor und/oder einen Hall-Sensor aufweist.

9. Vorrichtung nach einem der vorangehenden Ansprüche 1 bis 8,
wobei in dem von dem Magnetfeldschirm (2) umschlossenen Raum ein Mikrocontroller (11) zur Signalauswertung eines von dem magnetoresistiven Sensor (6) abgegebenen Messsignals angeordnet ist.

10. Vorrichtung nach Anspruch 9,
wobei der Magnetfeldschirm (2) den Mikrocontroller (11) vor externen Störfeldern und einer zu hohen Feldbelastung durch das von dem mindestens einen Stromleiter (3) erzeugte Magnetfeld schützt.

11. Vorrichtung nach einem der vorangehenden Ansprüche 1 bis 10,
wobei der von dem Magnetfeldschirm (2) umschlossene Stromleiter (3) ein flexibler oder starrer Stromleiter mit einem bestimmten Querschnitt aufweist.

12. Vorrichtung nach Anspruch 11,
wobei der von dem Magnetfeldschirm (2) umschlossene Stromleiter (3) einen Rundstromleiter mit kreisförmigem Querschnitt oder einen Stromleiter mit rechteckigem Querschnitt, insbesondere eine Stromsammelschiene, aufweist.

13. Vorrichtung nach einem der Ansprüche 4 bis 12,
wobei gelenkig miteinander verbundene Schirmteile des mehrteiligen Magnetfeldschirms (2) auf den Stromleiter (3) aufrastbar sind.

14. Vorrichtung nach einem der vorangehenden Ansprüche 1 bis 12,
wobei der Magnetfeldschirm (2) eine auf einer Platine (24) verlaufende Leiterbahn (3) oder eine in der Platine (24) integrierte Leiterbahn (3) umschließt.

15. Vorrichtung nach einem der vorangehenden Ansprüche 1 bis 14,
wobei die Sensitivitätsachse des magnetoresistiven Sensors (6) parallel zu Magnetfeldlinien MFL in dem Spaltbereich (4) des Magnetfeldschirms (2) verläuft.

16. Vorrichtung nach Anspruch 15,
wobei die Endabschnitte der beiden gegenüberliegenden Schenkel des u-förmigen Magnetfeldschirms (2) oder der beiden Endabschnitte des rohrschellenförmigen Magnetfeldschirms (2) durch zwei entsprechende Öffnungen (24A, 24B) einer Platine (24) auf einer ersten Seite der Platine (24) herausragen,
wobei sich zwischen den beiden herausragenden Endabschnitten der offene Spaltbereich (4) des Magnetfeldschirms (2) befindet und der magnetoresistive Sensor (6) auf der ersten Seite der Platine (24) in dem offenen Spaltbereich (4) angeordnet ist.

17. Vorrichtung nach Anspruch 16,
wobei der Stromleiter (3) eine auf der entgegengesetzten zweiten Seite der Platine (24) verlaufende Leiterbahn oder eine in der Platine (24) integrierte Leiterbahn ist, die von dem Magnetfeldschirm (2) umschlossen ist.

18. Vorrichtung nach einem der vorangehenden Ansprüche 1 bis 17,
wobei der magnetoresistive Sensor (6) einen durch den Stromleiter (3) fließenden Gleichstrom oder einen durch den Stromleiter (3) fließenden Wechselstrom oder gepulsten Strom einschließlich Oberwellen berührungslos erfasst.

19. Vorrichtung nach einem der vorangehenden Ansprüche 1 bis 18,
wobei der mindestens eine Stromleiter (3) eine Stromphase (L) für ein an ein Stromversorgungsnetz angeschlossenes Gerät (14) leitet.

20. Vorrichtung nach einem der vorangehenden Ansprüche 1 bis 19,
wobei der Magnetfeldschirm (2) ein amorphes Metall mit hoher Permeabilität und niedriger Remanenz aufweist.

21. Vorrichtung nach Anspruch 20,
wobei das amorphe Metall ein nickelhaltiges amorphes Metall, insbesondere Supra 50 oder Permalloy 80, aufweist.

22. Vorrichtung nach einem der vorangehenden Ansprüche 1 bis 21,
wobei der Magnetfeldschirm (2) mindestens zwei parallel angeordnete Stromleiter (3-1, 3-2) umschließt.

23. Vorrichtung nach Anspruch 22,
wobei die beiden parallel angeordneten Stromleiter (3-1, 3-2) antiparallel von zwei verschiedenen elektrischen Strömen, insbesondere von einem Hin- und Rückstrom, durchflossen werden und der magnetoresistive Sensor (6) eine Differenzstromstärke zwischen den Stromstärken der beiden elektrischen Ströme berührungslos erfasst.

24. Vorrichtung nach Anspruch 22,
wobei die parallel angeordneten Stromleiter parallel von in gleicher Richtung fließenden elektrischen Strömen durchflossen werden und der magnetoresistive Sensor eine Summenstromstärke der Stromstärke der parallel fließenden elektrischen Ströme berührungslos erfasst.

25. Vorrichtung nach einem der vorangehenden Ansprüche 1 bis 24,
wobei eine Auswerteeinheit (8) die sensorisch erfassten Stromstärken des mindestens einen Stromleiters (3), einer Summenstromstärke und/oder eine Differenzstromstärke auswertet.

26. Vorrichtung nach Anspruch 25,
wobei eine Steuereinheit (10) in Abhängigkeit von einem von der Auswerteeinheit (8) gelieferten Auswerteergebnis mindestens einen Aktor (13) ansteuert und/oder die Auswerteeinheit (8) das Auswertungsergebnis an eine externe Steuerung überträgt.
